(19) Europäisches Patentamt
European Patent Office
Office européen des brevets

(11) **EP 3 451 404 A1**

(12) **EUROPEAN PATENT APPLICATION**

(43) Date of publication:
**06.03.2019 Bulletin 2019/10**

(51) Int Cl.:
***H01L 51/54*** *(2006.01)*

(21) Application number: **18191309.6**

(22) Date of filing: **28.08.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **01.09.2017 KR 20170111935**

(71) Applicants:
- **Samsung Electronics Co., Ltd.**
  **Gyeonggi-do 16677 (KR)**
- **Ewha University-Industry Collaboration Foundation**
  **Seoul 03760 (KR)**

(72) Inventors:
- **IHN, Sooghang**
  **16678 Gyeonggi-do, (KR)**
- **YOU, Youngmin**
  **03760 Seoul (KR)**
- **KIM, Sonam**
  **03760 Seoul (KR)**
- **KIM, Sinheui**
  **03760 Seoul (KR)**
- **Yi, Seungyeon**
  **03760 Seoul (KR)**
- **KIM, Sunghan**
  **16678 Gyeonggi-do, (KR)**
- **NOH, Changho**
  **16678 Gyeonggi-do, (KR)**
- **SUL, Soohwan**
  **16678 Gyeonggi-do, (KR)**
- **SIM, Myungsun**
  **16678 Gyeonggi-do, (KR)**
- **LEE, Hasup**
  **16678 Gyeonggi-do, (KR)**

(74) Representative: **Elkington & Fife LLP**
**Prospect House**
**8 Pembroke Road**
**Sevenoaks, Kent TN13 1XR (GB)**

(54) **ORGANIC LIGHT-EMITTING DEVICE INCLUDING FLUORESCENT COMPOUND AND FLUORESCENT COMPOUND**

(57) Provided are an organic light-emitting device, which includes a fluorescent compound satisfying a predetermined condition, and a fluorescent compound.

FIG. 2

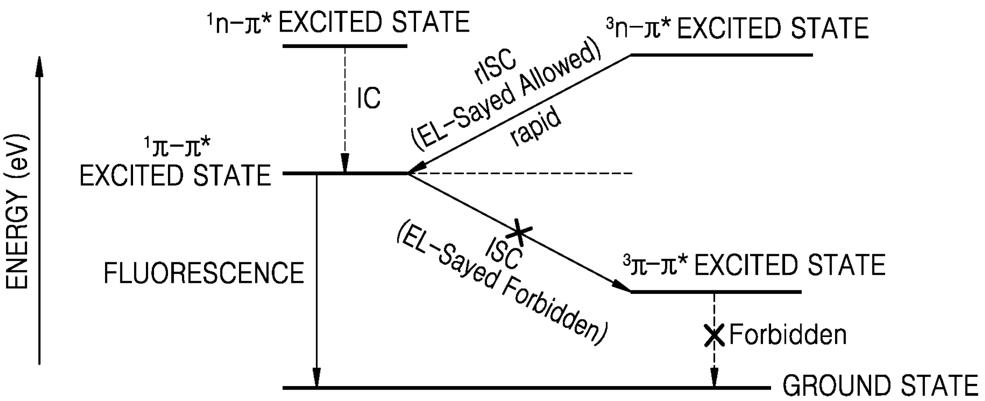


EP 3 451 404 A1

## Description

FIELD OF THE INVENTION

One or more embodiments relate to an organic light-emitting device including a fluorescent compound satisfying a predetermined condition, and to the fluorescent compound.

BACKGROUND OF THE INVENTION

Organic light-emitting devices (OLEDs) are self-emission devices that have wide viewing angles, high contrast ratios, short response times, and excellent characteristics in terms of brightness, driving voltage, and response speed, and produce full-color images.

In an example, an organic light-emitting device includes an anode, a cathode, and an organic layer that is disposed between the anode and the cathode and includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. Carriers, such as holes and electrons, recombine in an emission layer region to produce excitons. These excitons transit from an excited state to a ground state, thereby generating light.

Meanwhile, emission using a triplet exciton may include phosphorescence and thermally activated delayed fluorescence (TADF), but such phosphorescence and TADF have disadvantages in that compound deterioration is relatively rapid due to a relatively long exciton lifetime. Furthermore, a phosphorescent compound is a metal-containing compound using iridium, platinum, or the like, and in this regard, use of such a phosphorescent compound may cause a rise in device cost.

Thus, unlike a phosphorescent compound and a TADF compound, there is a need to develop a compound which is not an expensive transition metal-containing compound, such as iridium, platinum, or the like, having a new mechanisms, being capable of substantially preventing the compound deterioration, and also having high luminance and high emission efficiency.

SUMMARY OF THE INVENTION

One or more embodiments provide an organic light-emitting device including a fluorescent compound satisfying a predetermined condition, and also provide the fluorescent compound.

Additional aspects will be set forth in part in the description which follows and, in part, will be apparent from the description, or may be learned by practice of the presented embodiments.

An aspect provides an organic light-emitting device including:

a first electrode;
a second electrode facing the first electrode; and
an organic layer disposed between the first electrode and the second electrode and including an emission layer and a fluorescent compound,
wherein the fluorescent compound has $^3$n-$\pi^*$-to-$^1\pi$-$\pi^*$ transition from a $^3$n-$\pi^*$ excited state to a $^1\pi$-$\pi^*$ excited state,
an energy level (eV) in a $^1$n-$\pi^*$ excited state of the fluorescent compound is greater than an energy level (eV) in the $^1\pi$-$\pi^*$ excited state of the fluorescent compound,
the fluorescent compound emits fluorescence by radiative transition of an exciton thereof in the $^1\pi$-$\pi^*$ excited state to a ground state,
"$^3$" in the expression "$^3$n-$\pi^*$" indicates a triplet state, and "$^1$" in the expressions "$^1$n-$\pi^*$" and "$^1\pi$-$\pi^*$" indicates a singlet state, and
the energy level in the $^1$n-$\pi^*$ excited state, the energy level in the $^1\pi$-$\pi^*$ excited state, and the energy level in the $^3$n-$\pi^*$ excited state may each independently calculated by using structurally optimized time dependent-density functional theory (TD-DFT) at a CAM-B3LYP/6-311+G(d,p) level, preferably using the Gaussian 09 program.

Another aspect provides a fluorescent compound,
wherein the fluorescent compound has $^3$n-$\pi^*$-to-$^1\pi$-$\pi^*$ transition from a $^3$n-$\pi^*$ excited state to a $^1\pi$-$\pi^*$ excited state,
an energy level (eV) in a $^1$n-$\pi^*$ excited state of the fluorescent compound is greater than an energy level (eV) in the $^1\pi$-$\pi^*$ excited state of the fluorescent compound,
the fluorescent compound emits fluorescence by radiative transition of an exciton thereof in the $^1\pi$-$\pi^*$ excited state to a ground state,

"3" in the expression "$^3$n-π*" indicates a triplet state, and "1" in the expressions "$^1$n-π*" and "$^1$π-π*" indicates a singlet state, and

the energy level in the $^1$n-π* excited state, the energy level in the $^1$π-π* excited state, and the energy level in the $^3$n-π* excited state are each independently calculated by using structurally optimized time dependent-density functional theory (TD-DFT) at a CAM-B3LYP/6-311 +G(d,p) level, preferably using the Gaussian 09 program.

According to an aspect, there is provided a fluorescent compound, wherein a coumarin-based compound represented by Formula 1' is excluded therefrom:

<Formula 1'>

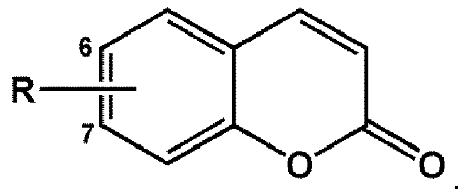

In Formula 1', R may be a $C_6$-$C_{50}$ aryl group positioned at the 6-position or 7-position of a coumarin ring in Formula 1'.

BRIEF DESCRIPTION OF THE DRAWINGS

These and/or other aspects will become apparent and more readily appreciated from the following description of the embodiments, taken in conjunction with the accompanying drawings in which:

FIG. 1 is an energy level diagram describing a luminescence mechanism of a fluorescent compound according to an embodiment;
FIG. 2 is an energy level diagram describing a luminescence mechanism of a fluorescent compound according to another embodiment;
FIG. 3 is a schematic cross-sectional view showing an organic light-emitting device according to an embodiment;
FIGS. 4 to 7 are each a graph of normalized photoluminescence intensity versus time (nanoseconds, ns) showing time-resolved PL spectroscopy (TRPL) plots with respect to Compound 4, BDpyInCz, Ir-C, and ACR, respectively;
FIG. 8A is a transient absorption spectrum obtained when an absorption variation (ΔmOD, a.u.) of an $N_2$-saturated acetonitrile solution of Compound 4 with respect to a wavelength (nm) is measured at 0.001 ns, 0.01 ns, 0.1 ns, and 1 ns after photoexcitation, respectively;
FIG. 8B shows a decay trace and nonlinear least square fitting of an absorption variation (ΔmOD, a.u.) of an $N_2$-saturated acetonitrile solution of Compound 4 with respect to time (ps) for light having a wavelength of 1,030 nm, respectively;
FIG. 9A is a transient absorption spectrum obtained when an absorption variation (ΔmOD, a.u.) of an air-saturated acetonitrile solution of Compound 4 with respect to a wavelength (nm) is measured at 0.001 ns, 0.01 ns, 0.1 ns, and 1 ns after photoexcitation, respectively; and
FIG. 9B shows a decay trace and nonlinear least square fitting of an absorption variation (ΔmOD, a.u.) of an air-saturated acetonitrile solution of Compound 4 with respect to time (ps) for light having a wavelength of 1,030 nm, respectively.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

FIG. 1 is a diagram describing a luminescence mechanism of a fluorescent compound according to an embodiment. Hereinafter, a fluorescent compound will be described with reference to FIG. 1.

The fluorescent compound may have $^3$n-π*-to-$^1$π-π* transition from a $^3$n-π* excited state to a $^1$π-π* excited state

(hereinafter, "the $^3$n-π*-to-$^1$π-π* transition"). That is, the fluorescent compound may have a $^3$n-π* excited state, and the transition from the $^3$n-π* excited state to the $^1$π-π* excited state may be measured.

In the fluorescent compound, the $^3$n-π*-to-$^1$π-π* transition may be confirmed by using an infrared ray (IR) transient absorption spectrometer (see Evaluation Example 3).

As shown in FIG. 1, an energy level (eV) in a $^1$n-π* excited state of the fluorescent compound may be greater (or, higher) than an energy level (eV) in the $^1$π-π* excited state of the fluorescent compound.

That is, an exciton in the $^1$n-π* excited state may be transferred to the $^1$π-π* excited state via internal conversion (IC), and does not contribute to light emission by direct transition to a ground state. Instead, a fluorescence may be emitted by radiative transition of an exciton in the $^1$π-π* excited state of the fluorescent compound to a ground state.

The energy level (eV) in the $^1$π-π* excited state of the fluorescent compound may have two or more different values (see Table 1). In other words, the energy level in the $^1$π-π* excited state can include one or more different energy levels in the $^1$π-π* excited state.

In one embodiment, the energy level in the $^3$n-π* excited state of the fluorescent compound may be greater (or, higher) than the energy level in the $^1$π-π* excited state of the fluorescent compound (see FIG. 1).

In one or more embodiments, the energy level in the $^3$n-π* excited state excited state of the fluorescent compound may be less (or, lower) than the energy level in the $^1$π-π* excited state of the fluorescent compound.

That is, the fluorescent compound may satisfy the energy level relationship of the energy level in the $^1$n-π* excited state > the energy level in the $^3$n-π* excited state > the energy level in the $^1$π-π* excited state or the energy level in the $^1$n-π* excited state >the energy level in the $^1$π-π* excited state > the energy level in the $^3$n-π* excited state.

In one or more embodiments, a difference between i) the energy level in the $^3$n-π* excited state of the fluorescent compound and ii) the lowest energy level of the energy level(s) in the $^1$π-π* excited state may be about 1.00 eV or less, for example, about 0.69 eV or less, and for example, about 0.3 eV or less. However, embodiments of the present disclosure are not limited thereto.

An exciton in the $^3$n-π* excited state of the fluorescent compound may be transferred to the $^1$π-π* excited state via reverse intersystem crossing (rISC). The fluorescence may be emitted by radiative transition of the exciton thereof in the $^1$π-π* excited state, which is transferred from the $^3$n-π* excited state of the fluorescent compound to the $^1$π-π* excited state of the fluorescent compound via reverse intersystem crossing (rISC), to a ground state. By this, although the fluorescent compound is not an expensive transition metal-containing compound, for example, using iridium, platinum, or the like, the fluorescent compound may achieve a theoretical 100% emission efficiency upon harvesting of triplet excitons. The fluorescent compound may be clearly distinguished from a phosphorescent compound in the art in terms of not including a transition metal, such as iridium, platinum, or the like.

Here, the rISC may be an allowed crossing according to the EL-Sayed's Rule, and thus, may have a very rapid speed. For example, a rate of the rISC may be in a range of about $10^6$ inverse seconds ($s^{-1}$) to about $10^8$ $s^{-1}$. For example, the rate of the rISC may be in a range of about $10^6$ $s^{-1}$ to about $10^7$ $s^{-1}$, and in one embodiment, may be in a range of about $10^7$ $s^{-1}$ to about $10^8$ $s^{-1}$, but embodiments of the present disclosure are not limited thereto. The rate of the rISC may be measured according to time-resolved PL spectroscopy (TRPL).

Although not particularly limited to a specific theory, the exciton in the $^3$n-π* excited state of the fluorescent compound may be transferred to the $^1$π-π* excited state via "the allowed and rapid" rISC according to the EL-Sayed's Rule, and thus, the fluorescent compound may have a relatively short exciton lifetime, i.e., a decay time. For example, the fluorescent compound may have an exciton lifespan in a range of about 0.1 nanoseconds (ns) to about 1 microsecond ($\mu$s), in one embodiment, in a range of about 1 ns to about 0.1 $\mu$s, and in one embodiment, in a range of about 1 ns to about 0.01 $\mu$s. In this regard, the fluorescent compound may be clearly distinguished from a thermally activated delayed fluorescent (TADF) compound whose exciton lifespan is relatively long due to intramolecular charge transfer (ICT) which is "forbidden and relatively slow" rISC.

As described above, the fluorescent compound having a short exciton lifetime (or decay time) may have a lower probability of deterioration, compared with a TADF compound having a relatively long exciton lifetime. Thus, an electronic device, for example, an organic light-emitting device, including the fluorescent compound may have a long lifetime.

In summary, the fluorescent compound having the emission mechanism of FIG. 1 may have the following advantages:

i) the fluorescent compound may emit fluorescence of high luminance and/or high emission efficiency, by radiative transition of an exciton thereof in the $^1$π-π* excited state having a large oscillator intensity to a ground state; and

ii) the exciton the fluorescent compound in the $^1$π-π* excited state, which is "rapidly" transferred from the $^3$n-π* excited state of the fluorescent compound to the $^1$π-π* excited state of the fluorescent compound via "allowed and rapid" reverse intersystem crossing (rISC) according to the EL-Sayed's Rule, may be also subjected to radiative transition from the $^1$π-π* excited state to a ground state, and thus, the fluorescent compound may have a relatively short exciton lifetime (or decay time). Therefore, the fluorescent compound may have a minimized probability of deterioration.

In one embodiment, the energy level in the $^3$n-$\pi$* excited state of the fluorescent compound may be less (or, lower) than the energy level in the $^3\pi$-$\pi$* excited state of the fluorescent compound (for example, see Compound 1 in Table 4). In one or more embodiments, as shown in FIG. 2, the energy level in the $^3$n-$\pi$* excited state of the fluorescent compound may be greater (or, higher) than the energy level in the $^3\pi$-$\pi$* excited state in the fluorescent compound.

FIG. 2 is a diagram describing an emission mechanism of a fluorescent compound according to another embodiment.

The fluorescent compound of FIG. 2 may have the same emission mechanism as the fluorescent compound of FIG. 1, except that the energy level in the $^3$n-$\pi$* excited state may be greater (or, higher) than the energy level in the $^3\pi$-$\pi$* excited state. Here, the transfer of the exciton in the $^1\pi$-$\pi$* excited state of the fluorescent compound to the $^3\pi$-$\pi$* excited state of the fluorescent compound via ISC is forbidden, and thus, substantially, the exciton in the $^3$n-$\pi$* excited state and the exciton in the $^3\pi$-$\pi$* excited state may not be subjected to directly-radiative transition to a ground state.

In the fluorescent compound, the energy level in the $^3\pi$-$\pi$* excited state may have two or more different values, that is, there can be a plurality of energy levels (or sublevels) in the energy level in the $^3\pi$-$\pi$* excited state.

In the present specification, "$^3$" in the expressions "$^3$n-$\pi$*" and "$^3\pi$-$\pi$*" indicates a triplet state, and "$^1$" in the expressions "$^1$n-$\pi$*" and "$^1\pi$-$\pi$*" indicates a singlet state. That is, the expressions "$^3$n-$\pi$*" and "$^3\pi$-$\pi$*" may be also respectively represented by "triplet n-$\pi$*" and "triplet $\pi$-$\pi$*", and the expressions "$^1$n-$\pi$*" and "$^1\pi$-$\pi$*" may be also respectively represented by "singlet n-$\pi$*" and "singlet $\pi$-$\pi$*".

In the present specification, the energy level in the $^1$n-$\pi$* excited state, the energy level in the $^1\pi$-$\pi$* excited state, the energy level in the $^3$n-$\pi$* excited state, and the energy level in the $^3\pi$-$\pi$* excited state may each independently be calculated by using structurally optimized time dependent-density functional theory (TD-DFT) at a CAM-B3LYP/6-311 +G(d,p) level, preferably using the Gaussian 09 program. A detailed description for the calculation may be referred by Evaluation Examples below.

The fluorescent compound may include a non-bonding orbital (for example, a non-bonding $\pi$ orbital) which is able to induce the above-described $^3$n-$\pi$*-to-$^1\pi$-$\pi$* transition.

For example, the fluorescent compound may include at least one carbonyl group.

In one embodiment, the fluorescent compound may be represented by Formula 1 or 2:

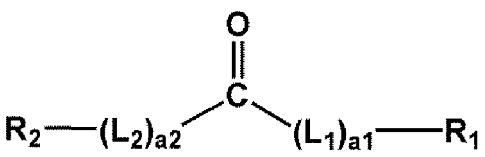

1

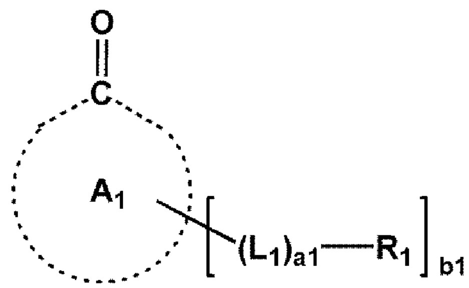

2

In Formulae 1 and 2,

ring $A_1$ may be a carbonyl-containing $C_5$-$C_{60}$ carbocyclic group or a carbonyl-containing $C_1$-$C_{60}$ heterocyclic group,
$L_1$ and $L_2$ may each independently be a substituted or unsubstituted $C_1$-$C_{60}$ alkylene group, a substituted or unsubstituted $C_2$-$C_{60}$ alkenylene group, a substituted or unsubstituted $C_2$-$C_{60}$alkynylene group, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,
a1 and a2 may each independently be an integer from 0 to 20,
$R_1$ and $R_2$ may each independently be selected from hydrogen, deuterium, -F, -Cl, - Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted

$C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -B($Q_6$)($Q_7$), and -P(=O)($Q_8$)($Q_9$),
b1 may be an integer from 1 to 20,
at least one substituent of the substituted $C_1$-$C_{60}$ alkylene group, the substituted $C_2$-$C_{60}$ alkenylene group, the substituted $C_2$-$C_{60}$alkynylene group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, substituted divalent non-aromatic condensed polycyclic group, substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, substituted monovalent non-aromatic condensed polycyclic group, and the substituted monovalent non-aromatic condensed heteropolycyclic group may be selected from:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, - $CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a C1-C10 heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - N($Q_{11}$)($Q_{12}$), -Si($Q_{13}$)($Q_{14}$)($Q_{15}$), -B($Q_{16}$)($Q_{17}$), and -P(=O)($Q_{18}$)($Q_{19}$);
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, -$CD_3$, -$CD_2H$, -$CDH_2$, - $CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_{21}$)($Q_{22}$), - Si($Q_{23}$)($Q_{24}$)($Q_{25}$), -B($Q_{26}$)($Q_{27}$), and -P(=O)($Q_{28}$)($Q_{29}$); and
-N($Q_{31}$)($Q_{32}$), -Si($Q_{33}$)($Q_{34}$)($Q_{35}$), -B($Q_{36}$)($Q_{37}$), and -P(=O)($Q_{38}$)($Q_{39}$), and

$Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

For example, ring $A_1$ in Formula 2 may be i) a $C_2$-$C_5$ 5-membered ring including a carbonyl group, ii) a $C_2$-$C_6$

6-membered ring including a carbonyl group, and iii) a condensed ring in which at least one first ring and at least one second ring are condensed, wherein the first ring is selected from a $C_2$-$C_5$ 5-membered ring including a carbonyl group and a $C_2$-$C_6$ 6-membered ring including a carbonyl group, and the second ring is selected from a $C_2$-$C_5$ 5-membered ring including a carbonyl group, a $C_2$-$C_6$ 6-membered ring including a carbonyl group, a $C_2$-$C_5$ 5-membered ring not including a carbonyl group, and a $C_2$-$C_6$ 6-membered ring not including a carbonyl group.

The terms "a carbonyl-containing $C_5$-$C_{60}$carbocyclic group", "a carbonyl-containing $C_1$-$C_{60}$ heterocyclic group", "a $C_2$-$C_5$ 5-membered ring including a carbonyl group" and "a $C_2$-$C_6$ 6-membered ring including a carbonyl group" may each be a cyclic group including at least one carbonyl group as a ring-forming moiety, and the terms "a $C_2$-$C_5$ 5-membered ring not including a carbonyl group" and "a $C_2$-$C_6$ 6-membered ring not including a carbonyl group" may each be a cyclic group not including a carbonyl group as a ring-forming moiety.

In the specification, the carbon of the carbonyl group included as a ring-forming moiety in "a carbonyl-containing $C_5$-$C_{60}$carbocyclic group", "a carbonyl-containing $C_1$-$C_{60}$ heterocyclic group", "a $C_2$-$C_5$ 5-membered ring including a carbonyl group", and "a $C_2$-$C_6$ 6-membered ring including a carbonyl group" is also counted as a ring-forming atom. Thus, for example, a $C_2$-$C_5$ 5-membered ring including a carbonyl group is a cyclic group having a carbon atom of the carbonyl group and 1 to 4 other carbon atoms as ring members.

In one embodiment, the ring $A_1$ may include at least one carbon as a ring-forming atom, or at least one carbon and at least one oxygen as a ring-forming atom.

In other embodiment, ring-forming atoms of the ring $A_1$ may consist of a carbon, or atoms of the ring $A_1$ may consist of a carbon and an oxygen.

In other embodiment, a core represented by

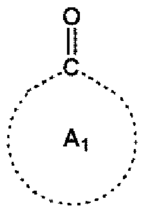

in Formula 2 may be a group represented by one of Formulae 2-1 to 2-15, but embodiments of the present disclosure are not limited thereto:

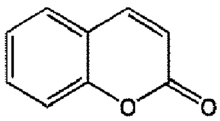
2-1

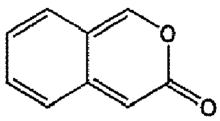
2-2

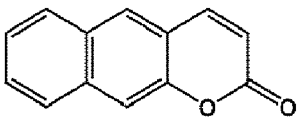
2-3

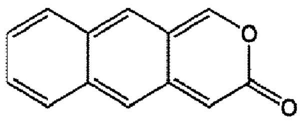
2-4

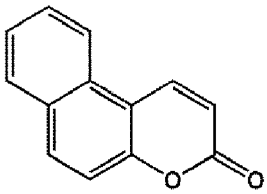
2-5

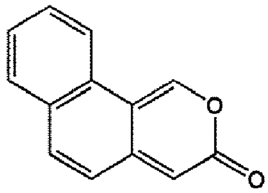
2-6

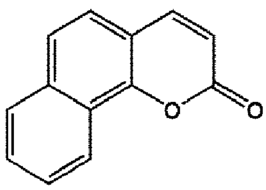
2-7

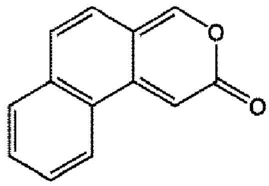
2-8

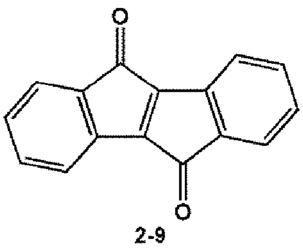
2-9

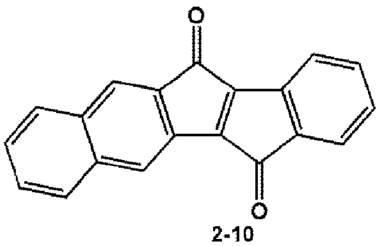
2-10

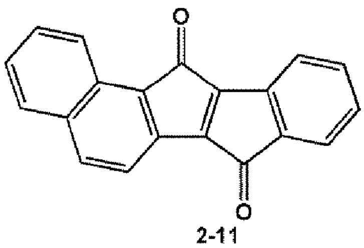
2-11

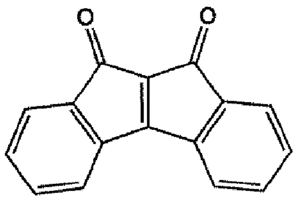

2-12

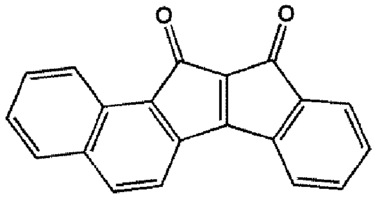

2-13

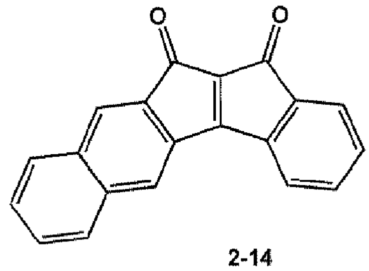

2-14

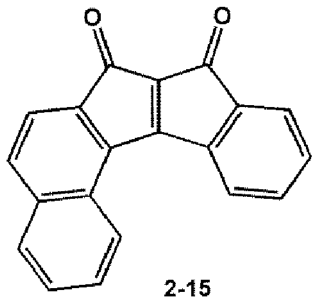

2-15

For example, a group represented by Formula 2-1 may be interpreted as a condensed ring in which a first ring, which is a $C_5$ 6-membered ring including a carbonyl group, and a second ring, which is a $C_6$ 6-membered ring not including a carbonyl group (such as a benzene group), are condensed.

In one embodiment, a group represented by Formula 2-9 may be interpreted as a condensed ring in which two first rings, each of which is a $C_5$ 5-membered ring including a carbonyl group, and two second rings, each of which is a $C_6$ 6-membered ring not including a carbonyl group (such as a benzene), are condensed.

In one or more embodiments, in Formulae 1 and 2, $L_1$ and $L_2$ may each independently be selected from a $C_1$-$C_{20}$ alkylene group, a $C_2$-$C_{20}$ alkenylene group, a $C_2$-$C_{20}$ alkynylene group, a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, a dibenzocarbazolylene group, and an imidazopyridinylene group, each unsubstituted or substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a

dibenzocarbazolyl group, an imidazopyridinyl group, an imidazopyrimidinyl group, and -Si($Q_{33}$)($Q_{34}$)($Q_{35}$). Here, $Q_{33}$ to $Q_{35}$ may each independently be the same as described above.

In one or more embodiments, in Formulae 1 and 2, a1 and a2 each indicate the number of $L_1$ and the number of $L_2$, wherein, when a1 is 0, *-$(L_1)_{a1}$-*' may be a single bond, and when a2 is 0, *-$(L_2)_{a2}$-*' may be a single bond. When a1 is two or more, two or more of Li(s) may be identical to or different from each other, and when a2 is two or more, two or more of $L_2$(s) may be identical to or different from each other.

For example, in Formulae 1 and 2, a1 and a2 may each independently be 0, 1, 2, or 3, but embodiments of the present disclosure are not limited thereto.

In one or more embodiments, $R_1$ and $R_2$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;

a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, - $CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an

imidazopyrimidinyl group, and $-Si(Q_{33})(Q_{34})(Q_{35})$; and
$-N(Q_1)(Q_2)$, $-Si(Q_3)(Q_4)(Q_5)$, $-B(Q_6)(Q_7)$, and $-P(=O)(Q_8)(Q_9)$, and
$Q_1$ to $Q_9$ and $Q_{33}$ to $Q_{35}$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, and $-CD_2CDH_2$;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group,

but embodiments of the present disclosure are not limited thereto.

In Formula 2, b1 indicates the number of $*-(L_1)_{a1}-R_1$, wherein, when b1 is two or more, two or more of $*-(L_1)_{a1}-R_1$(s) may be identical to or different from each other.
For example, b1 may be 1, 2, 3, or 4, but embodiments of the present disclosure are not limited thereto.
In one or more embodiments, the fluorescent compound may be one selected from Compounds 1 to 8, but embodiments of the present disclosure are not limited thereto:

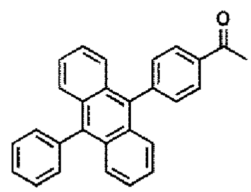
1

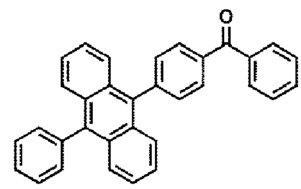
2

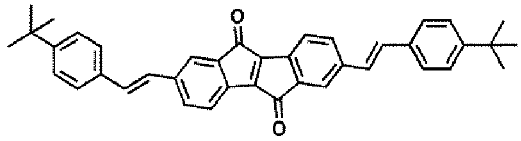
3

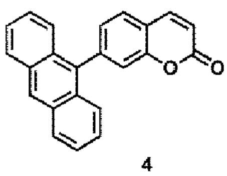
4

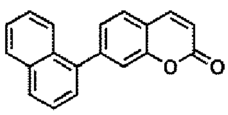
5

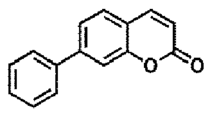
6

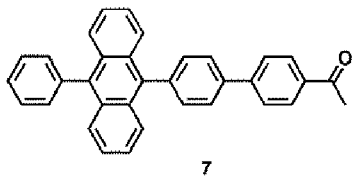
7

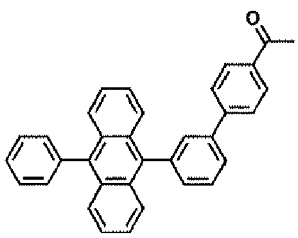
8

In an embodiment, the above-described fluorescent compound may be included in an emission layer of an organic light-emitting device.
The fluorescent compound included in the emission layer may emit, for example, fluorescence according to the emission mechanism of FIG. 1 or 2.
Thus, in an embodiment, a ratio of an emission portion of the fluorescence emitted by radiative transition of the exciton thereof in the $^1\pi$-$\pi^*$ excited state, transferred from the $^3n$-$\pi^*$ excited state of the fluorescent compound to the $^1\pi$-$\pi^*$ excited state of the fluorescent compound via reverse intersystem crossing (rISC), to a ground state, to a total emission portion emitted from the emission layer may be at least 90%, for example, at least 92%, and in one embodiment, at least 95%. However, embodiments of the present disclosure are not limited thereto. In other words, at least 90% of the total light emission from the emission layer is the fluorescent light emission from the fluorescent compound via reverse intersystem crossing.

In an embodiment, the emission layer may consist of the fluorescent compound.

In one or more embodiments, the emission layer may further include, in addition to the above-described fluorescent compound, any host. The host may be one type of a compound, or a mixture of two different types of a compound. When the emission layer further includes a host, the fluorescent compound included in the emission layer may serve as a fluorescence emitter, wherein an amount of the fluorescent compound may be smaller than that of the host.

For example, the host may include at least one compound selected from a fluorene-containing compound, a carbazole-containing compound, a dibenzofuran-containing compound, a dibenzothiophene-containing compound, indeno carbazole-containing compound, an indolocarbazole-containing compound, a benzofurocarbazole-containing compound, a benzothienocarbazole-containing compound, an acridine-containing compound, a dihydroacridine-containing compound, a triindolobenzene-containing compound, a pyridine-containing compound, a pyrimidine-containing compound, a triazine-containing compound, a silicon-containing compound, a cyano group-containing compound, a phosphine oxide-containing compound, a sulfoxide-containing compound, and a sulfonyl-containing compound.

For example, the host may be a compound including at least one carbazole ring and at least one cyano group, or a phosphine oxide-containing compound, but embodiments of the present disclosure are not limited thereto.

The host may include, for example, at least one compound selected from CBP, mCBP (Compound H7 below), and Compounds H1 to H24 below, but embodiments of the present disclosure are not limited thereto:

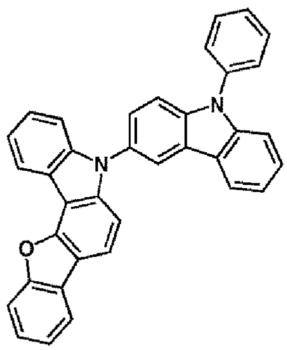
H1

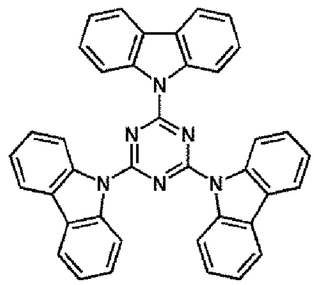
H2

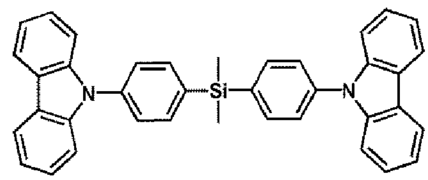
H3

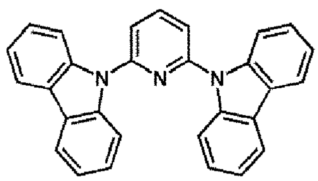
H4

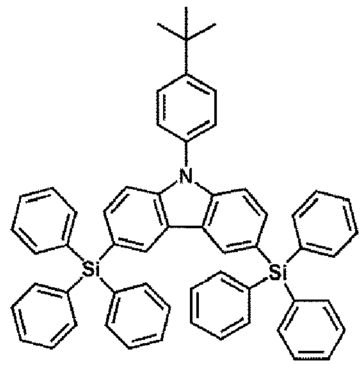
H5

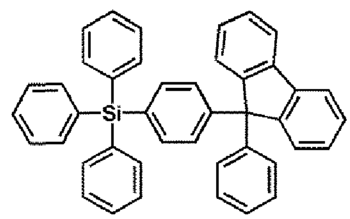
H6

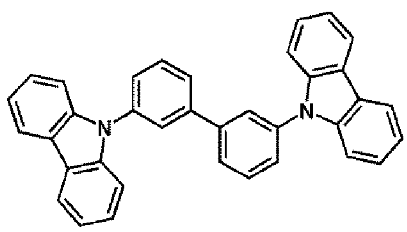
H7

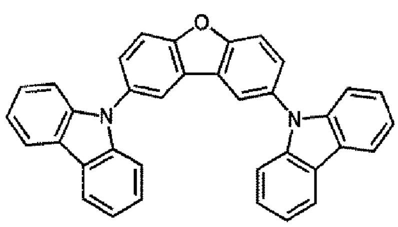
H8

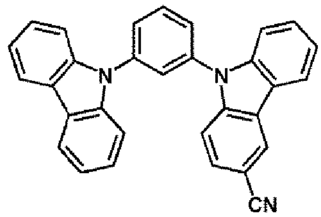
H9

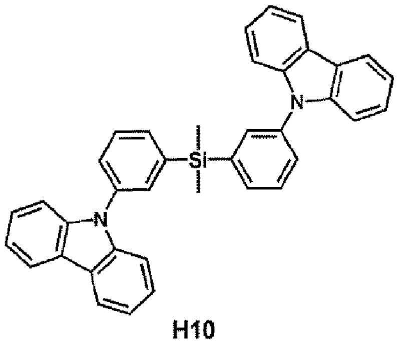

H10

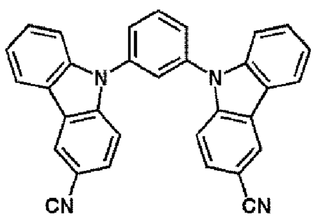

H11

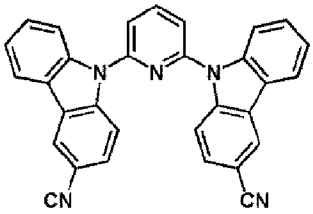

H12

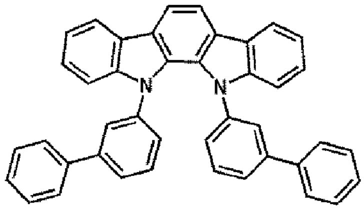

H13

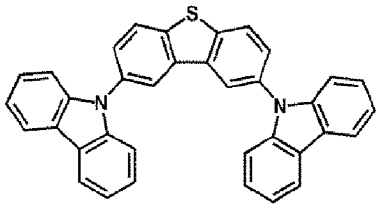

H14

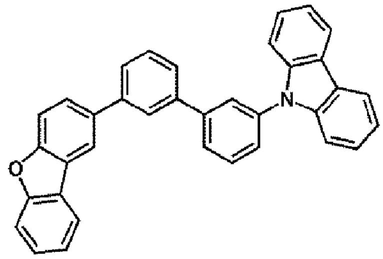

H15

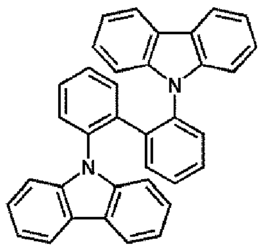

H16

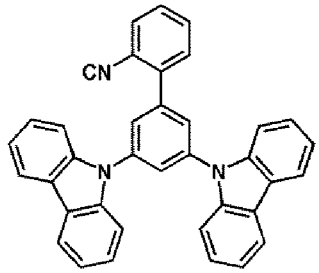

H17

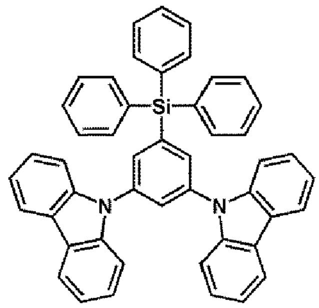

H18

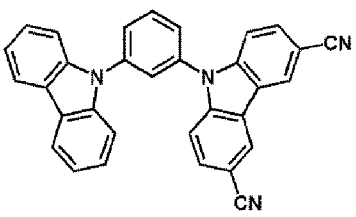

H19

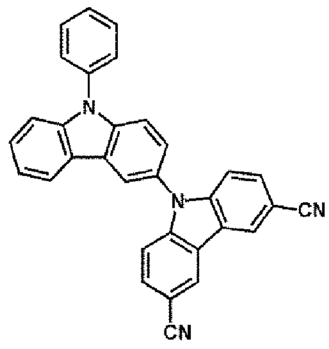

H20

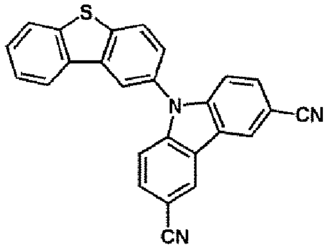

H21

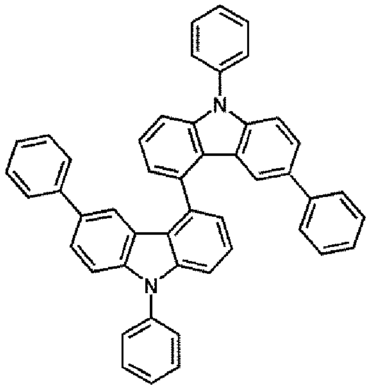

H22

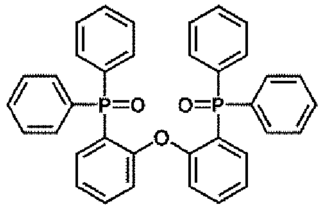

H23

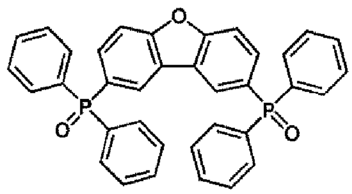

H24

The organic light-emitting device includes a hole transport region disposed between the first electrode and the emission layer and an electron transport region disposed between the emission layer and the second electrode, and the hole transport region includes a hole injection layer, a hole transport layer, an electron blocking layer, an buffer layer or any combination thereof, and the electron transport region includes a hole blocking layer, an electron transport layer, an electron injection layer, or any combination thereof.

FIG. 3 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 3. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100 to about 500°C, a vacuum pressure of about $10^{-8}$ to about $10^{-3}$ torr, and a deposition rate of about 0.01 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is

performed to remove a solvent after coating may be from about 80°C to about 200°C.

However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), polyaniline/poly(4-styrenesulfonate) (PANI/PSS), a compound represented by Formula 201 below, and a compound represented by Formula 202 below:

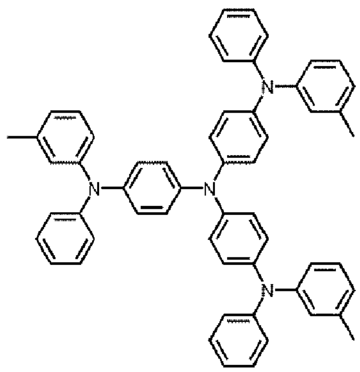

m-MTDATA

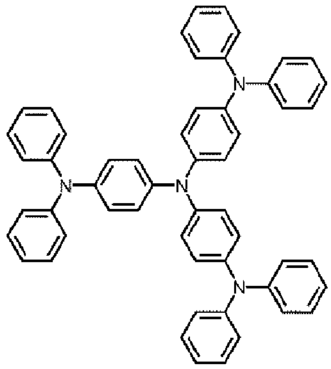

TDATA

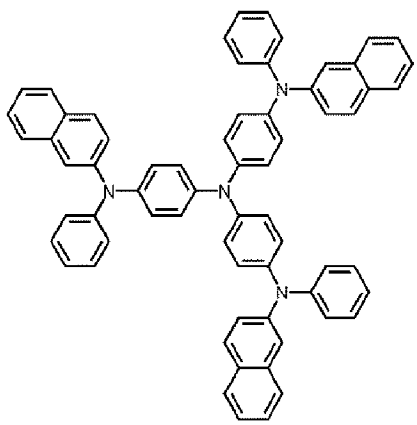

2-TNATA

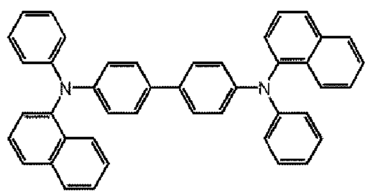

NPB

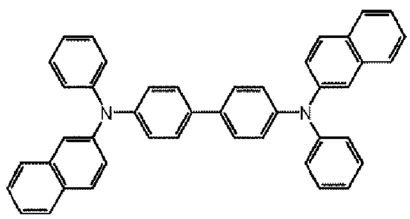

β-NPB

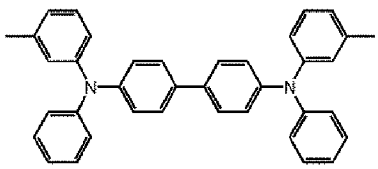

TPD

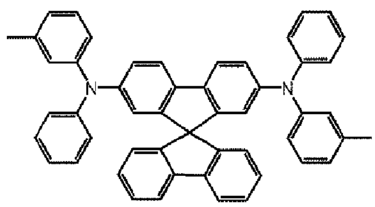

Spiro-TPD

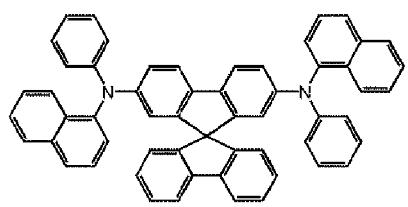

Spiro-NPB

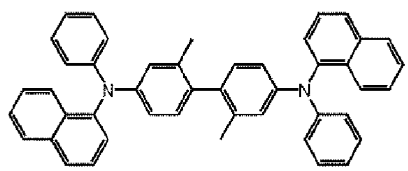

methylated NPB

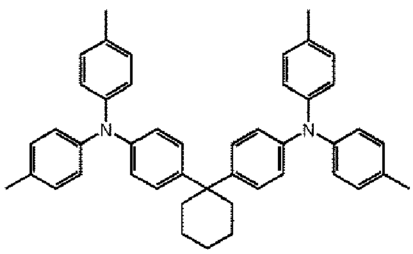

TAPC

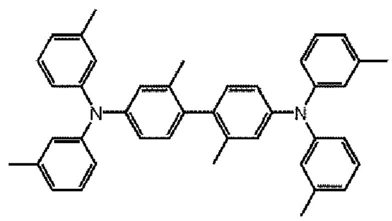

HMTPD

<Formula 201>

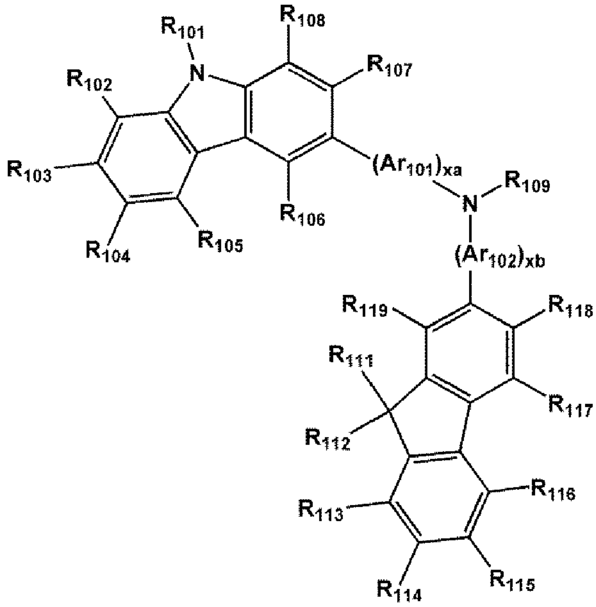

<Formula 202>

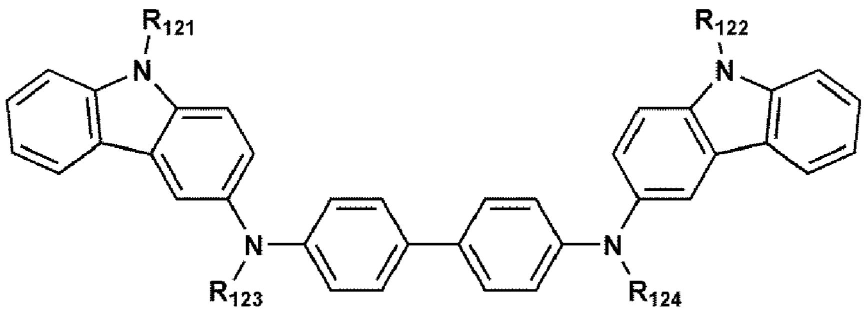

.

$Ar_{101}$ and $Ar_{102}$ in Formula 201 may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arythio group, a $C_1$-$C_{60}$ heteroaryl group, a monovalent non-aromatic condensed polycyclic group, and a monovalent non-aromatic condensed heteropolycyclic group.

In Formula 201, xa and xb may each independently be an integer from 0 to 5, or may be 0, 1, or 2. For example, xa is 1 and xb is 0, but xa and xb are not limited thereto.

$R_{101}$ to $R_{108}$, $R_{111}$ to $R_{119}$, and $R_{121}$ to $R_{124}$ in Formulae 201 and 202 may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and so on), and a $C_1$-$C_{10}$ alkoxy group (for example, a methoxy group, an ethoxy group, a propoxy group, a butoxy group, a pentoxy group, and so on);
a $C_1$-$C_{10}$ alkyl group or a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$alkyl group, or a $C_1$-$C_{10}$ alkoxy group, but embodiments of the present disclosure are not limited thereto.

In Formula 201, $R_{109}$ may be selected from:

a phenyl group, a naphthyl group, an anthracenyl group, and a pyridinyl group; and
a phenyl group, a naphthyl group, an anthracenyl group, and a pyridinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

In an embodiment, the compound represented by Formula 201 may be represented by Formula 201A, but embodiments of the present disclosure are not limited thereto:

<Formula 201A>

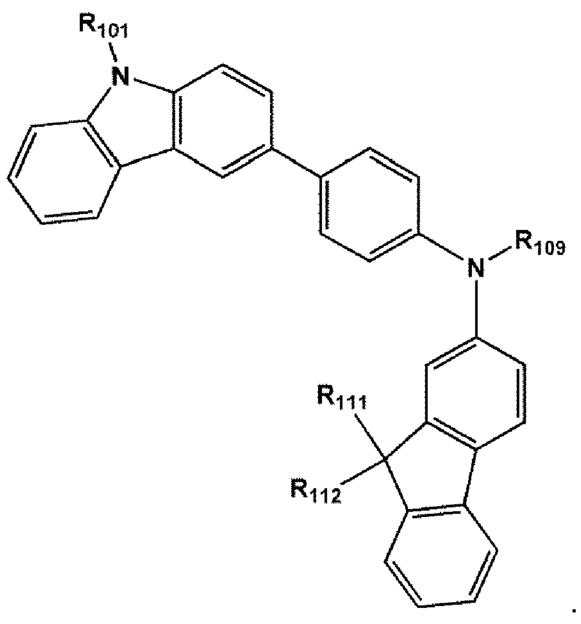

$R_{101}$ $R_{111}$, $R_{112}$, and $R_{109}$ in Formula 201A may be understood by referring to the description provided herein.
For example, the compound represented by Formula 201, and the compound represented by Formula 202 may include compounds HT1 to HT20 illustrated below, but are not limited thereto:

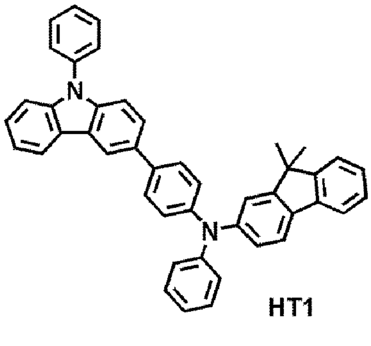

HT1

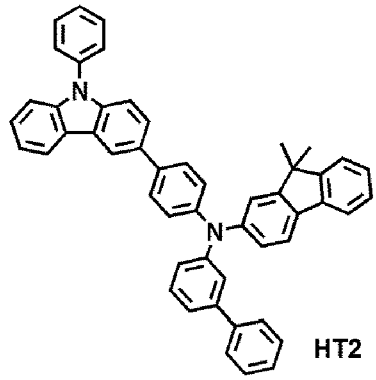

HT2

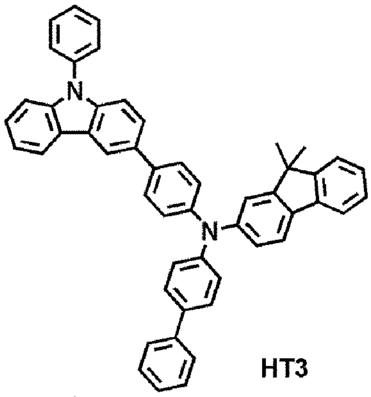

HT3

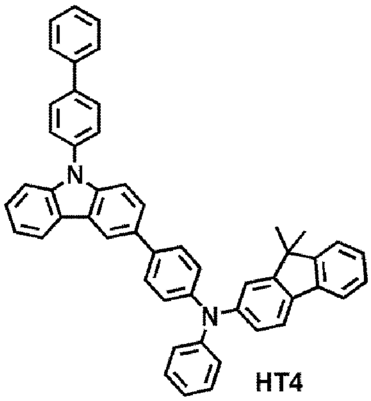

HT4

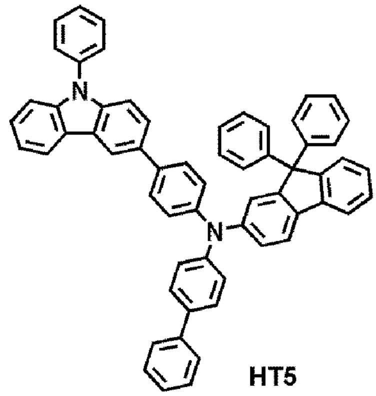

HT5

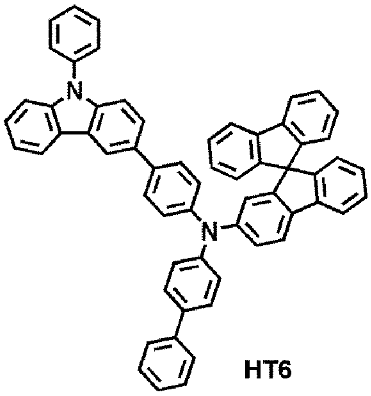

HT6

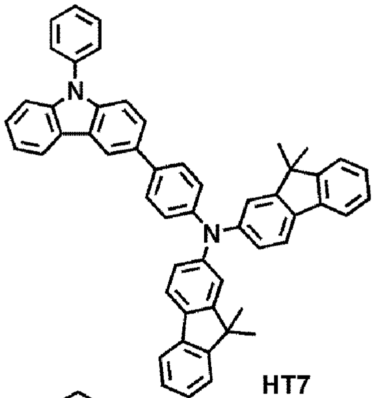

HT7

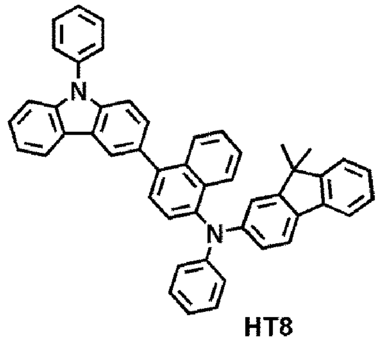

HT8

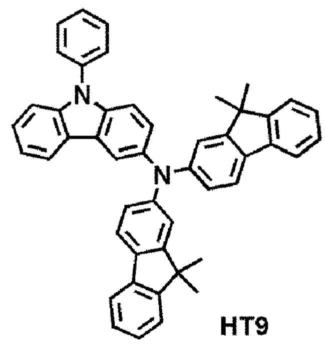

HT9

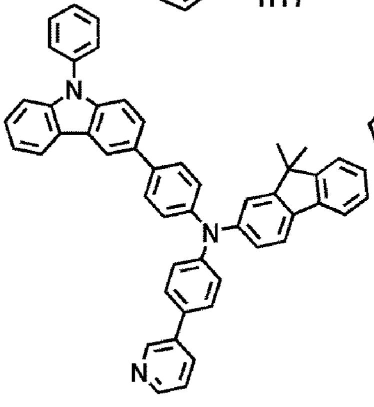

HT10

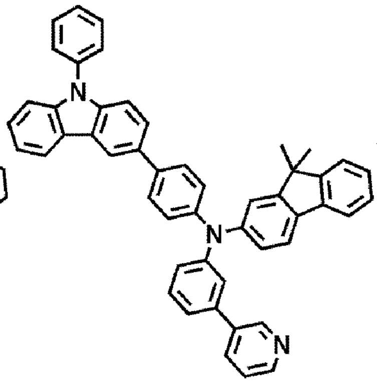

HT11

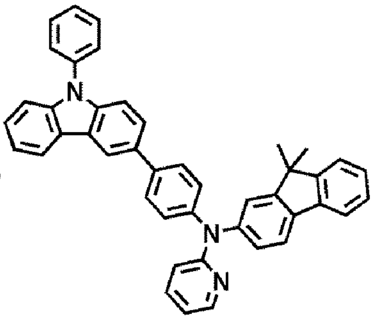

HT12

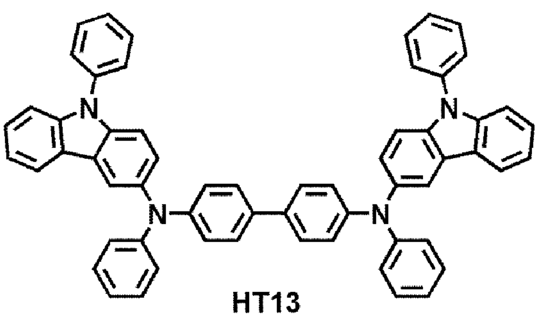

HT13

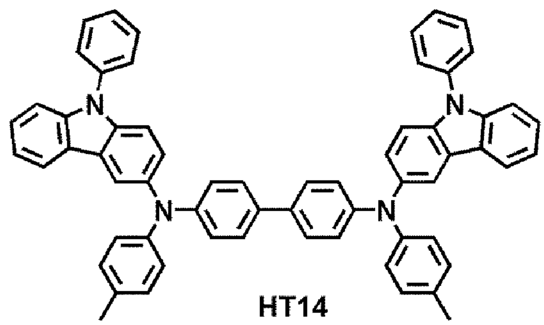

HT14

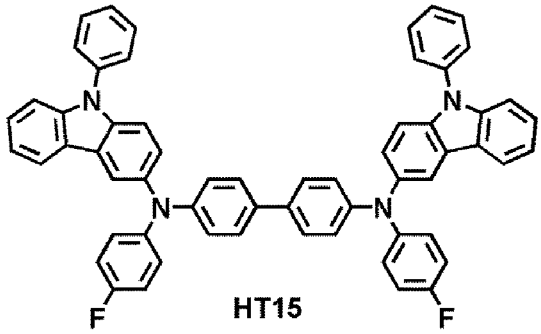

HT15

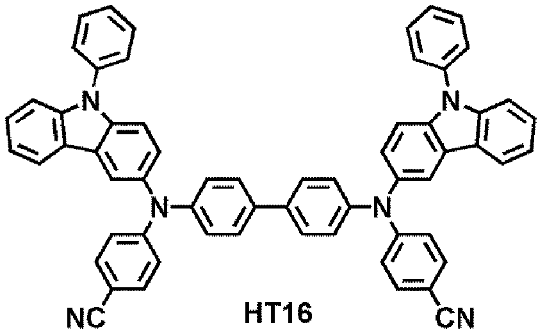

HT16

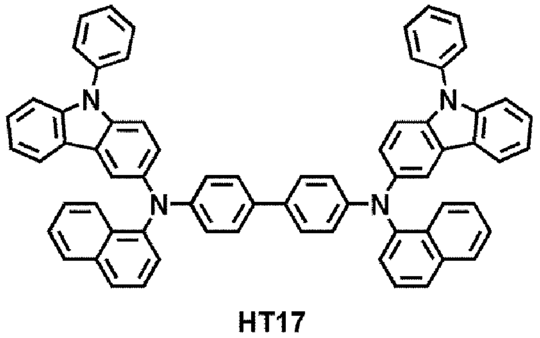

HT17

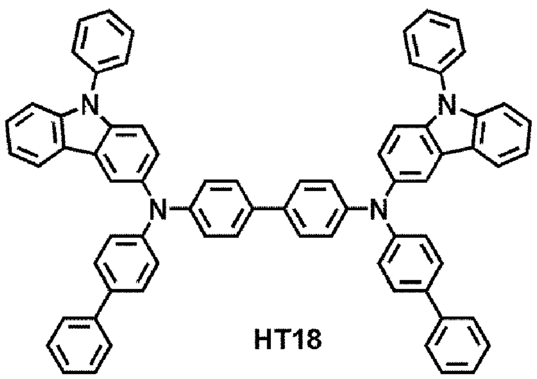

HT18

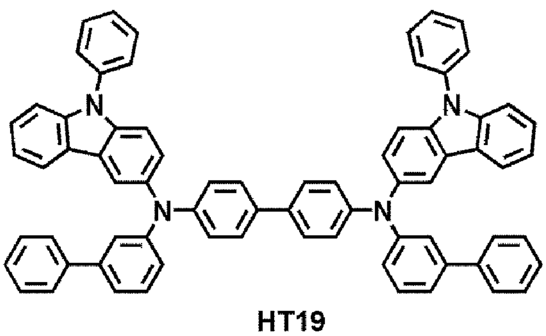

HT19

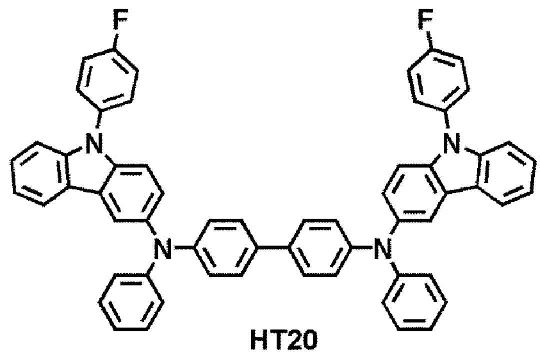

HT20

.

A thickness of the hole transport region may be in a range of about 100 Å to about 10,000 Å, for example, about 100 Å to about 3,000 Å. When the hole transport region includes at least one of a hole injection layer and a hole transport layer, the thickness of the hole injection layer may be in a range of about 100 Å to about 10,000 Å, and for example, about 100 Å to about 2,000 Å, and the thickness of the hole transport layer may be in a range of about 50 Å to about 2,000 Å, and for example, about 100 Å to about 1500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenum oxide; and a cyano group-containing compound, such as Compound HT-D1 or Compound HT-D2 below, but are not limited thereto:

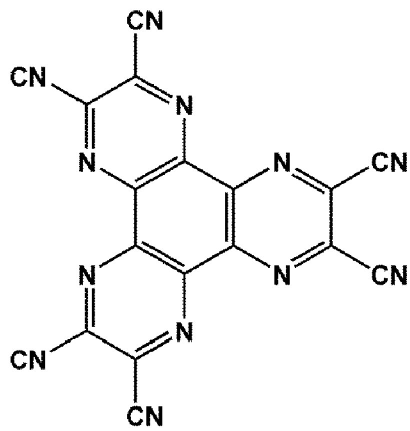

HT-D1

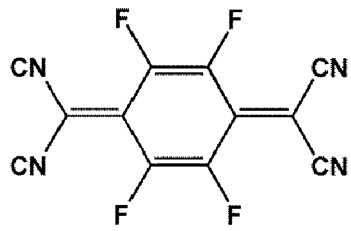

F4-TCNQ

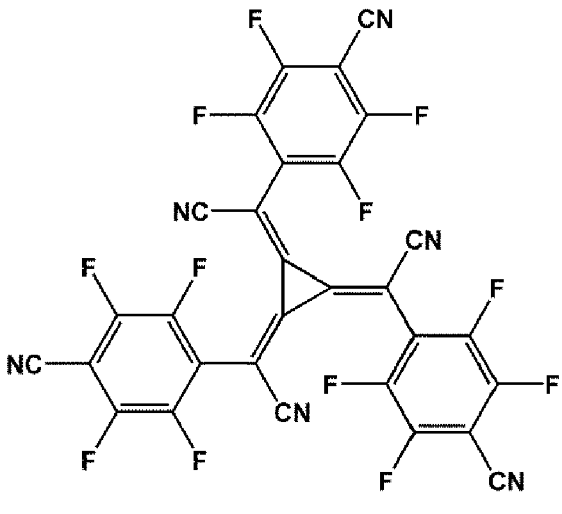

HT-D2

The hole transport region may include a buffer layer.

Also, the buffer layer may compensate for an optical resonance distance according to a wavelength of light emitted from the emission layer, and thus, efficiency of a formed organic light-emitting device may be improved.

The electron transport region may further include an electron blocking layer. The electron blocking layer may include, for example, mCP, but a material therefor is not limited thereto:

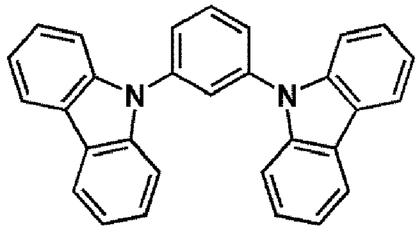

mCP

.

For example, as a material for the electron blocking layer, the host included in the emission layer may be used, but embodiments of the present disclosure are not limited thereto.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

The emission layer may include a fluorescent compound that satisfies the conditions described herein. The emission layer may consist of the fluorescent compound, or may further include any host in addition to the fluorescent compound. The host is the same as described above.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP and Bphen, but may also include other materials:

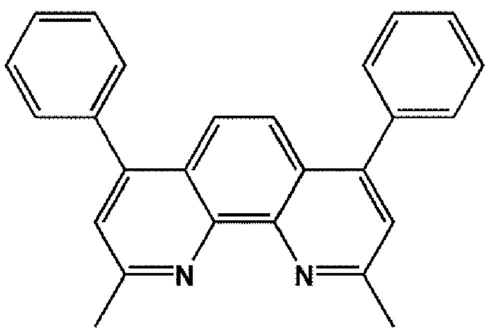

BCP

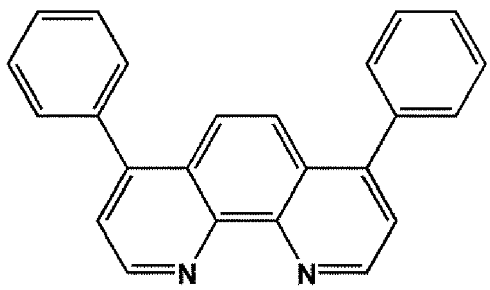

Bphen

.

For example, as a material for the hole blocking layer, a compound identical to the host included in the emission layer may be used, but embodiments of the present disclosure are not limited thereto.

A thickness of the hole blocking layer may be in a range of about 20 Å to about 1,000 Å, for example, about 30 Å to about 300 Å. When the thickness of the hole blocking layer is within these ranges, the hole blocking layer may have improved hole blocking ability without a substantial increase in driving voltage.

The electron transport layer may further include at least one selected from BCP, Bphen, $Alq_3$, BAlq, TAZ, and NTAZ:

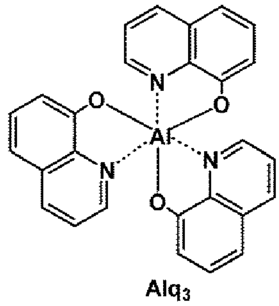

Alq$_3$

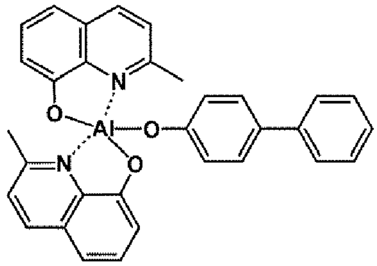

BAlq

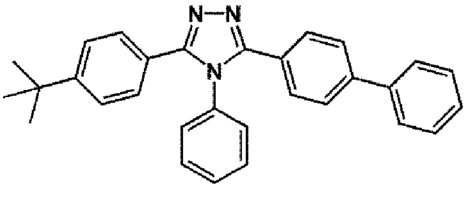

TAZ

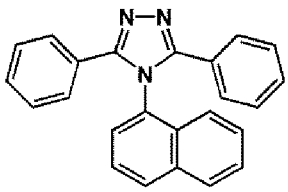

NTAZ .

In one or more embodiments, the electron transport layer may include at least one of ET1 to ET25, but are not limited thereto:

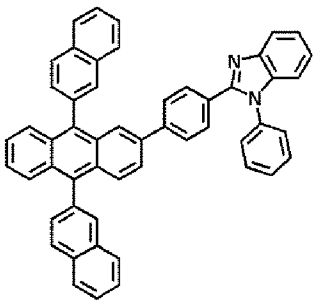

ET1

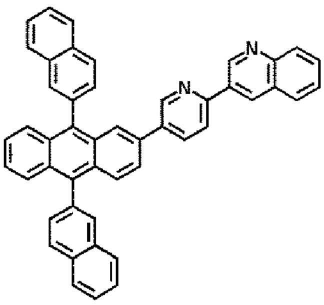

ET2

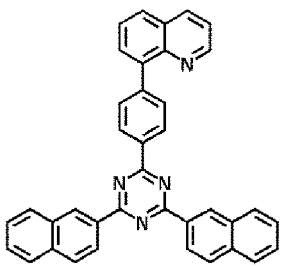

ET3

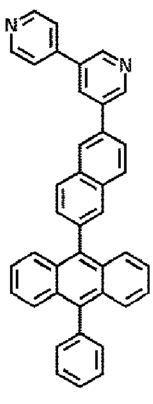

ET4

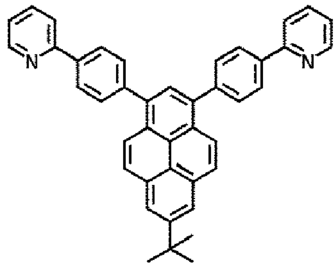

ET5

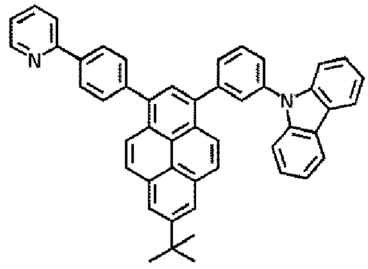

ET6

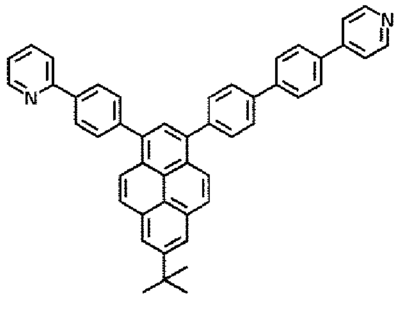

ET7

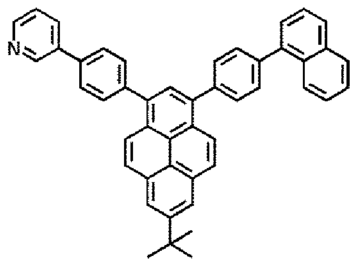

ET8

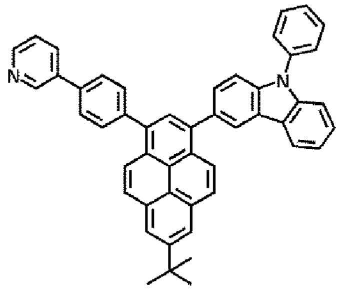

ET9

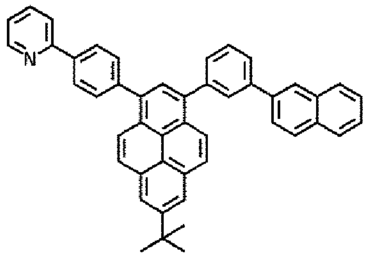

ET10

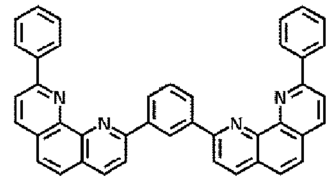

ET11

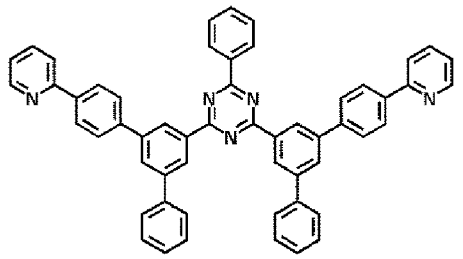

ET12

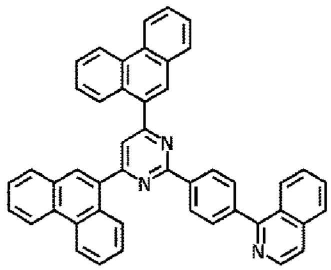

ET13

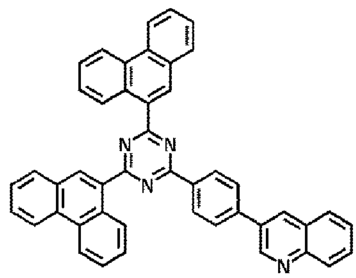

ET14

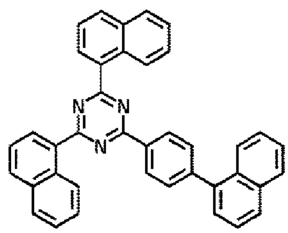

ET15

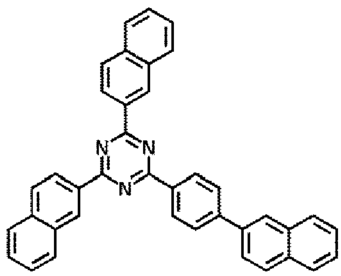

ET16

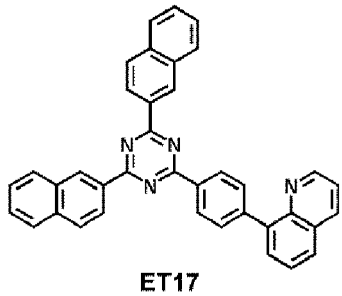

ET17

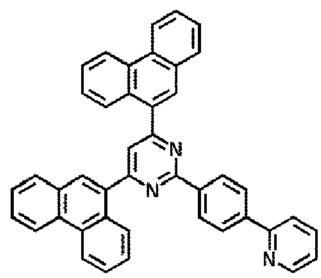

ET18

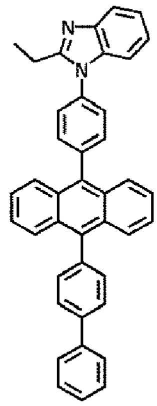
ET19

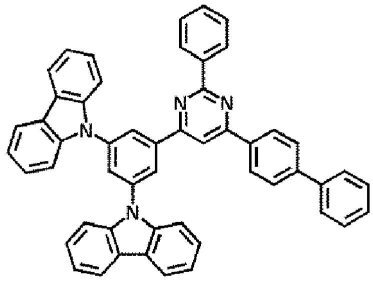
ET20

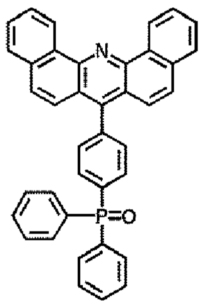
ET21

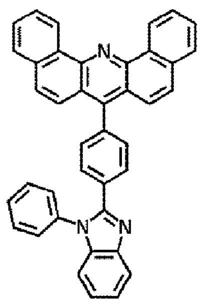
ET22

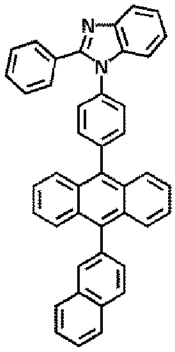
ET23

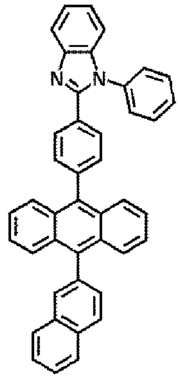
ET24

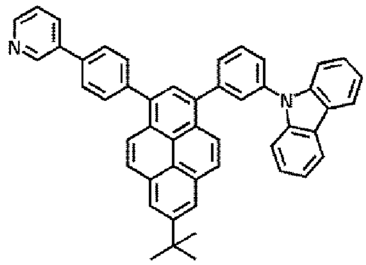
ET25

.

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or ET-D2:

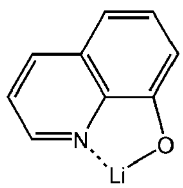
ET-D1

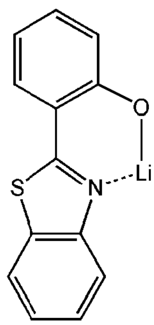
ET-D2

.

The electron transport region may include an electron injection layer that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, for example, about 3 Å to about 90 Å. When the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIG. 3, but embodiments of the present disclosure are not limited thereto.

According to another aspect, there is provided fluorescent compound, wherein the fluorescent compound may have $^3$n-$\pi$*-to-$^1\pi$-$\pi$* transition from a $^3$n-$\pi$* excited state to a $^1\pi$-$\pi$* excited state,

an energy level (eV) in a $^1$n-$\pi$* excited state of the fluorescent compound is greater than an energy level (eV) in the $^1\pi$-$\pi$* excited state of the fluorescent compound,

the fluorescent compound emits fluorescence by radiative transition of an exciton thereof in the $^1\pi$-$\pi$* excited state to a ground state,

"3" in the expression "$^3$n-$\pi$*" indicates a triplet state, and "1" in the expressions "$^1$n-$\pi$*" and "$^1\pi$-$\pi$*" indicates a singlet state, and

the energy level in the $^1$n-$\pi$* excited state, the energy level in the $^1\pi$-$\pi$* excited state, and the energy level in the $^3$n-$\pi$* excited state may each independently calculated by using the Gaussian 09 program based on the structurally optimized time dependent-density functional theory (TD-DFT) at a CAM-B3LYP/6-311+G(d,p) level, and

a coumarin-based compound represented by Formula 1' is excluded from the fluorescent compound:

<Formula 1'>

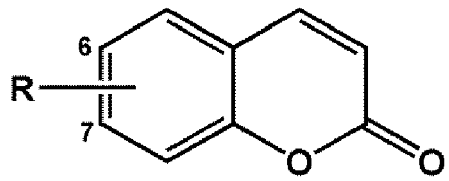

,

In Formula 1', R may be a $C_6$-$C_{50}$ aryl group positioned at the 6-position or 7-position of a coumarin ring in Formula 1'. The 6-position and 7-position are identified in Formula 1' as "6" and "7", respectively.

The fluorescent compound may be the same as described in connection with the fluorescent compound included in the organic light-emitting device above, except that the coumarin-based compound represented by Formula 1' is excluded from the fluorescent compound. In other words, the fluorescent compound is not the coumarin-based compound of Formula 1'.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by -$OA_{101}$ (wherein $A_{101}$ is the $C_1$-$C_{60}$ alkyl group), and non-limiting examples thereof include a methoxy group, an ethoxy group, and an isopropyloxy group.

The term "$C_2$-$C_{60}$ alkenyl group" as used herein refers to a hydrocarbon group formed by substituting at least one double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic

group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a heterocyclic aromatic system that has at least one heteroatom selected from N, O, P, Si, and S as a ring-forming atom, and 1 to 60 carbon atoms. The term "$C_1$-$C_{60}$ heteroarylene group" as used herein refers to a divalent group having a heterocyclic aromatic system that has at least one heteroatom selected from N, O, P, Si and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "carbonyl group" as used herein refers to a divalent group of the formula *-C(=O)-*' (* and *' indicate a binding site with a neighboring atom, respectively).

The term "$C_6$-$C_{60}$ aryloxy group" used herein indicates $-OA_{102}$ (wherein $A_{102}$ is the $C_6$-$C_{60}$ aryl group), and a $C_6$-$C_{60}$ arylthio group used herein indicates $-SA_{103}$ (wherein $A_{103}$ is the $C_6$-$C_{60}$ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{60}$ carbocyclic group" as used herein refers to a saturated or unsaturated cyclic group having, as a ring-forming atom, 5 to 60 carbon atoms only. The $C_5$-$C_{60}$ carbocyclic group may be a monocyclic group or a polycyclic group.

The term "$C_1$-$C_{60}$ heterocyclic group" as used herein refers to a saturated or unsaturated cyclic group having, as a ring-forming atom, at least one heteroatom selected from N, O, Si, P, and S other than 1 to 60 carbon atoms. The $C_1$-$C_{60}$ heterocyclic group may be a monocyclic group or a polycyclic group.

In the present application, at least one substituent of the substituted $C_1$-$C_{60}$ alkylene group, the substituted $C_2$-$C_{60}$ alkenylene group, the substituted $C_2$-$C_{60}$alkynylene group, the substituted $C_3$-$C_{10}$cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, substituted divalent non-aromatic condensed polycyclic group, substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the

substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted C1-$C_{60}$ heteroaryl group, substituted monovalent non-aromatic condensed polycyclic group, and the substituted monovalent non-aromatic condensed heteropolycyclic group may be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a C2-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, - $CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $N(Q_{11})(Q_{12})$, $-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy 0group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, - $CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, - $Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

The term "room temperature" as used herein refers to about 25°C.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

**[Examples]**

**Synthesis Example 1 (Compound 4)**

Synthesis of Intermediate 4-1 (7-bromocoumarin)

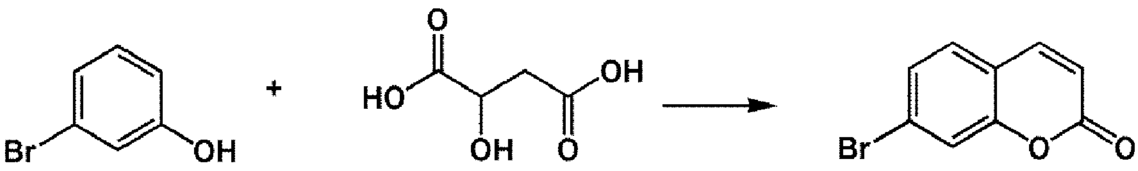

4-1

At a temperature of 0°C, 98% $H_2SO_4$ (6.5 mL) was added dropwise to a mixture of 3-bromophenol (5.00 g, 28.9 mmol) and DL-malic acid (2.60 g, 19.4 mmol), and the mixed solution was heated at a temperature of 120°C for 6 hours. The crushed ice was poured into the reaction mixture thus obtained, and the precipitated solid was filtered. A filter cake collected therefrom was washed with water to remove residual $H_2SO_4$. Then, the resulting product was dissolved in $CH_2Cl_2$, dried with anhydrous $MgSO_4$, and concentrated under vacuum. The resulting product thus obtained was purified by silica gel chromatography using $CH_2Cl2$:n-hexane at a ratio of 1:1 (v/v)), thereby obtaining Intermediate 4-1 (white powder, yield of 34%).

$^1H$ NMR (400 MHz, $CDCl_3$) δ : 6.44 (d, *J* = 9.6 Hz, $^1H$), 7.33-7.43 (m, $^2H$), 7.52 (d, *J* = 2.0 Hz, $^1H$), 7.66 (d, *J* = 9.6 Hz, $^1H$).

$^{13}C$ NMR (75 MHz, $CDCl_3$) δ : 117.01, 117.90, 120.29, 125.93, 128.02, 128.97, 142.92, 154.40, 160.01.

Synthesis of Compound 4

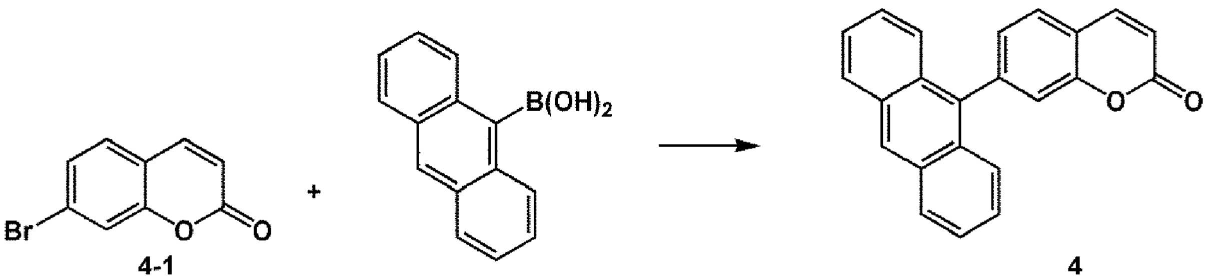

4-1 4

Intermediate 4-1 (0.300 g, 1.33 mmol), anthracen-10-yl-10-boronic acid (1.60 mmol), and tetrakis(triphenylphosphine)palladium (0) (0.077 g, 0.07 mmol) were added to a 100 mL round-bottom flask, and a mixture of THF and 2N $K_2CO_3$ aqueous solution (2:1 (v/v)) was added thereto, and the mixed solution was refluxed for 2 days. After completion of the reaction, water was poured into the reaction mixture, and the resulting mixture was cooled. An organic layer extracted therefrom by using $CH_2Cl_2$ (100 mL x 4 times) was dried with $MgSO_4$, and concentrated. The resulting product thus obtained was purified by silica gel chromatography while increasing the polarity of the eluent from $CH_2Cl2$:n-hexane (at 1:2 (v/v)) to $CH_2Cl2$:n-hexane (at 1:1 (v/v)), the thereby obtaining Compound 4 (yellow powder, yield of 28%).

$^1H$ NMR (300 MHz, $CDCl_3$) δ : 6.55 (d, *J* = 9.6 Hz, $^1H$), 7.35-7.41 (m, $^3H$), 7.46-7.51 (m, $^3H$), 7.59-7.62 (m, $^2H$), 7.70 (d, *J* = 7.5 Hz, $^1H$), 7.88 (d, *J* = 9.6 Hz, $^1H$), 8.08 (d, *J* = 8.4 Hz, $^2H$), 8.56 (s, $^1H$).

$^{13}C$ NMR (126 MHz, $CDCl_3$) δ : 117.00, 118.31, 119.79, 125.43, 126.12, 126.17, 127.68, 127.93, 128.69, 129.96, 131.40, 134. 62, 143.40, 143.44, 154.29, 160.87.

**Synthesis Example 2 (Compound 1)**

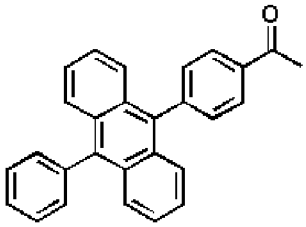

1

9-bromo-10-phenylanthracene (0.20 g, 0.60 mmol), 4-acetylphenylboronic acid (0.17 g, 1.02 mmol), and tetrakis(triphenylphosphine)palladium(0) (0.14 g, 0.12 mmol) were mixed with 50 mL of tetrahydrofuran (THF) at room temperature, and 25 mL of 2N $K_2CO_3$(aq) was added thereto. Then, the mixed solution was heated at a temperature 70 °C for 90 hours. Water and $CH_2Cl_2$ were added to the reaction mixture obtained therefrom and shaken violently to extact a reaction product dissolved in a $CH_2Cl_2$ layer. Then, $MgSO_4$ was added thereto so as to remove water dissolved in the $CH_2Cl_2$ layer, and filtering was performed thereon by using a glass filter. The resulting product obtained therefrom was purified by silica gel column chromatography of EtOAc:*n*-hexane (1:3 (v/v)) to obtain Compound 1 (yellow powder, yield of 45%).

$^1$H NMR (300 MHz, $CDCl_3$) $\delta$ (ppm): 2.76 (s, 3H), 7.32-7.37 (m, 4H), 7.46-7.50 (m, 2H), 7.60-7.63 (m, 7H), 7.70-7.73 (m, 2H), 8.22 (d, *J* = 8.7 Hz, 2H).

$^{13}$C NMR (126 MHz, $CD_2Cl_2$) $\delta$ (ppm): 27.18, 125.65, 125.91, 126.95, 127.56, 128.15, 128.94, 129.00, 130.07, 130.37, 131.76, 132.23, 136.31, 137.05, 138.29, 139.37, 144.85, 198.22.

## Synthesis Example 3 (Compound 2)

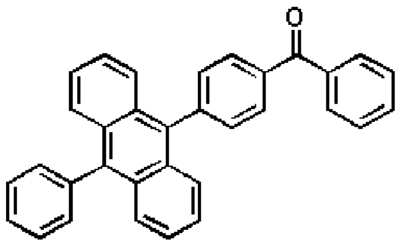

2

9-bromo-10-phenylanthracene (0.20 g, 0.60 mmol), 4-benzoylphenylboronic acid (0.28 g, 1.26 mmol), and tetrakis(triphenylphosphine)palladium(0) (0.21 g, 0.18 mmol) were mixed with 50 mL of tetrahydrofuran (THF) at room temperature, and 25 mL of 2N $K_2CO_3$ (aq) was added thereto. The mixed solution was heated at a temperature of 70°C for 72 hours. Water and $CH_2Cl_2$ were added to the reaction mixture obtained therefrom and shaken violently to extact a reaction product dissolved in a $CH_2Cl_2$ layer. Then, $MgSO_4$ was added thereto so as to remove water dissolved in the $CH_2Cl_2$ layer, and filtering was performed thereon by using a glass filter. The resulting product obtained therefrom was purified by silica gel column chromatography of $CH_2Cl_2$:*n*-hexane (1:2 (v/v)) to obtain Compound 2 (yellow powder, yield of 96%).

$^1$H NMR (300 MHz, $CDCl_3$) $\delta$ (ppm): 7.33-7.40 (m, 4H), 7.47-7.50 (m, 2H), 7.55-7.66 (m, 8H), 7.67-7.74 (m, 4H), 7.97-8.00 (m, 2H), 8.08 (d, *J* = 1.8 Hz, 2H).

$^{13}$C NMR (126 MHz, $CD_2Cl_2$) $\delta$ (ppm): 30.36, 125.68, 125.92, 127.07, 127.57, 128.15, 128.94, 129.02, 130.14, 130.40, 130.61, 130.72, 131.78, 131.95, 133.05, 136.38, 137.41, 138.28, 139.39, 144.24, 196.75.

## Synthesis Example 4 (Compound 7)

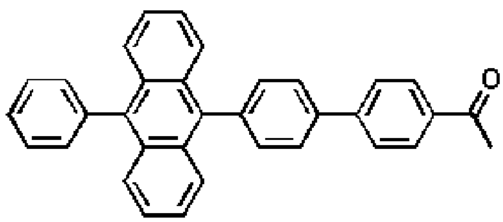

7

9-(4-bromophenyl)-10-phenylanthracene (0.20 g, 0.49 mmol), 4-acetylphenylboronic acid (0.17 g, 1.02 mmol), and tetrakis(triphenylphosphine)palladium(0) (0.34 g, 0.29 mmol) were mixed with 50 mL of tetrahydrofuran (THF) at room temperature, and 25 mL of 2N $K_2CO_3$ (aq) was added thereto. The mixed solution was heated at a temperature of 70°C for 38 hours. The mixed solution was heated at a temperature of 70°Cfor 72 hours. Water and $CH_2Cl_2$ were

added to the reaction mixture obtained therefrom and shaken violently to extact a reaction product dissolved in a $CH_2Cl_2$ layer. Then, $MgSO_4$ was added thereto so as to remove water dissolved in the $CH_2Cl_2$ layer, and filtering was performed thereon by using a glass filter. The resulting product obtained therefrom was purified by silica gel column chromatography of EtOAc : n-hexane (1:2 (v/v)) to obtain Compound 7 (yellow powder, yield of 19%).

$^1$H NMR (300 MHz, $CDCl_3$) $\delta$ (ppm): 2.70 (s, 3H), 7.33-7.40 (m, 4H), 7.48-7.51 (m, 2H), 7.56-7.64 (m, 5H), 7.69-7.78 (m, 4H), 7.87-7.90 (m, 4H), 8.13 (d, *J* = 8.4 Hz, 2H).

$^{13}$C NMR (126 MHz, $CD_2Cl_2$) $\delta$ (ppm): 27.11, 125.62, 125.72, 127.29, 127.52, 127.74, 127.83, 128.11, 129.00, 129.52, 130.39, 130.44, 131.81, 132.54, 136.70, 136.98, 137.94, 139.50, 139.55, 139.68, 145.78, 197.98.

## Synthesis Example 5 (Compound 8)

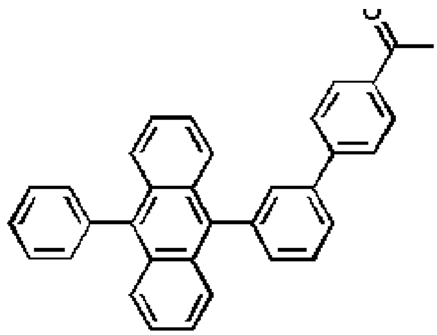

8

9-(3-bromophenyl)-10-phenylanthracene (0.20 g, 0.49 mmol), 4-acetylphenylboronic acid (0.16 g, 0.98 mmol), and tetrakis(triphenylphosphine)palladium(0) (0.23 g, 0.20 mmol) were dissolved in 50 mL of tetrahydrofuran (THF) at room temperature, and 25 mL of 2N $K_2CO_3$ (aq) was added thereto. The mixed solution was heated at a temperature of 70°C for 96 hours. The mixed solution was heated at a temperature of 70°Cfor 72 hours. Water and $CH_2Cl_2$ were added to the reaction mixture obtained therefrom and shaken violently to extact a reaction product dissolved in a $CH_2Cl_2$ layer. Then, $MgSO_4$ was added thereto so as to remove water dissolved in the $CH_2Cl_2$ layer, and filtering was performed thereon by using a glass filter. The resulting product obtained therefrom was purified by silica gel column chromatography of EtOAc : *n*-hexane (1:7 (v/v)) to obtain Compound 8 (yellow powder, yield of 86%).

$^1$H NMR (300 MHz, $CD_2Cl_2$) $\delta$ (ppm): 2.61 (s, 3H), 7.33-7.39 (m, 4H), 7.47-7.50 (m, 2H), 7.52-7.55 (m, 1H), 7.58-7.64 (m, 3H), 7.68-7.72 (m, 3H), 7.73-7.79 (m, 2H), 7.77-7.83 (m, 3H), 7.87-7.90 (m, 1H), 8.01-8.05 (m, 2H).

$^{13}$C NMR (126 MHz, $CD_2Cl_2$) $\delta$ (ppm): 27.05, 30.25, 125.63, 125.76, 126.91, 127.31, 127.50, 127.79, 128.11, 129.00, 129.41, 129.70, 130.43, 130.65, 131.78, 131.80, 136.67, 137.14, 137.96, 139.48, 140.36, 140.56, 145.73, 197.91.

## Evaluation Example 1

First, regarding Compounds 1 to 4, 7 and 8, an energy level in a singlet excited state and an energy level in a triplet excited state for each compound was calculated by using the Gaussian 09 program based on density functional theory (DFT)-dependent quantum chemistry calculation. The results determining an energy level in a $^1$n-$\pi$* excited state, an energy level in a $^1\pi$-$\pi$* excited state, an energy level in a $^3$n-$\pi$* excited state, and an energy level in a $^3\pi$-$\pi$* excited state are shown in Table 1.

Here, geometry optimization and single point calculation of model structures were performed using the long range corrected version of B3LYP using the Coulomb-attenuating method (CAM-B3LYP) and 6-311 +G(d,p) basis set. A polarizable continuum model (CPCM) parameterized for THF was applied during the geometry optimization step. Then, frequency calculation was performed in order to assess stability of convergence. Time-dependent-density functional theory (TD-DFT) calculation was applied to the optimized geometries using the same functionals and basis sets that were used for geometry optimization. The CPCM parameterized for THF was applied to account for salvation effects. The twenty lowest singlet and triplet states were calculated and analyzed.

Meanwhile, the non-bonding and the $\pi$ orbital were determined based on the topologies thereof, and the oscillator strengths and the expansion coefficients were obtained by a log file.

[Table 1]

| Compound No. | 1 | 2 | 3 | 4 | 7 | 8 |
|---|---|---|---|---|---|---|
| Energy level (eV) in $^{1}n$-$\pi^*$ excited state | 3.78 | 3.82 | 2.05 | 4.06 | 3.78 | 3.78 |
| Energy level (eV) in $^{1}\pi$-$\pi^*$ excited state | 3.52 | 3.58 | 1.35 | 3.80, 3.11 | 3.51 | 3.52 |
| Energy level (eV) in $^{3}n$-$\pi^*$ excited state | 3.43 | 3.20 | 2.04 | 2.81 | 3.43 | 3.44 |
| Energy level (eV) in $^{3}\pi$-$\pi^*$ excited state | 3.21 | 2.21 | 1.68, 0.78, | 3.46, 3.29 | 2.21 | 2.21 |

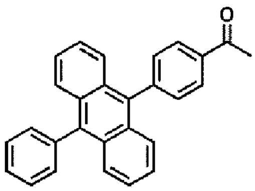

1

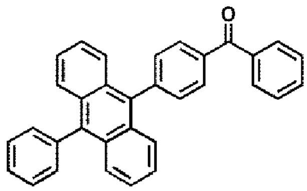

2

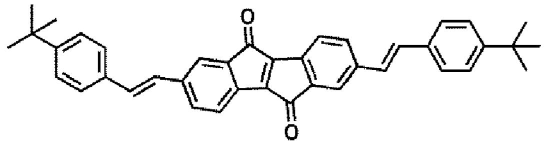

3

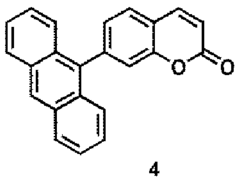

4

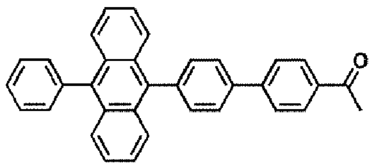

7

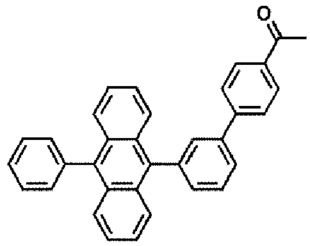

8

Referring to Table 1, it was confirmed that, in Compounds 1 to 4, 7 and 8, the energy level in the $^{1}n$-$\pi^*$ excited state was higher than that in the $^{1}\pi$-$\pi^*$ excited state.

**Evaluation Example 2**

A quartz substrate washed with acetone isopropyl alcohol and pure water was prepared, and then, predetermined materials shown in Table 2 were vacuum-(co)-deposited thereon at a vacuum degree of $10^{-7}$ torr, thereby preparing Films 1, A, B, and C, each having a thickness of 50 nm.

[Table 2]

| Film No. | Compounds used for film preparation |
|---|---|
| Film 1 | Compound 4 and mCBP (at a volume ratio of 15:85) |
| Film A | BDpyInCz and mCBP (at a volume ratio of 15:85) |
| Film B | Ir-C and mCBP (at a volume ratio of 15:85) |
| Film C | ACR and mCBP (at a volume ratio of 15:85) |

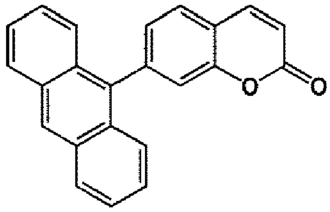

4

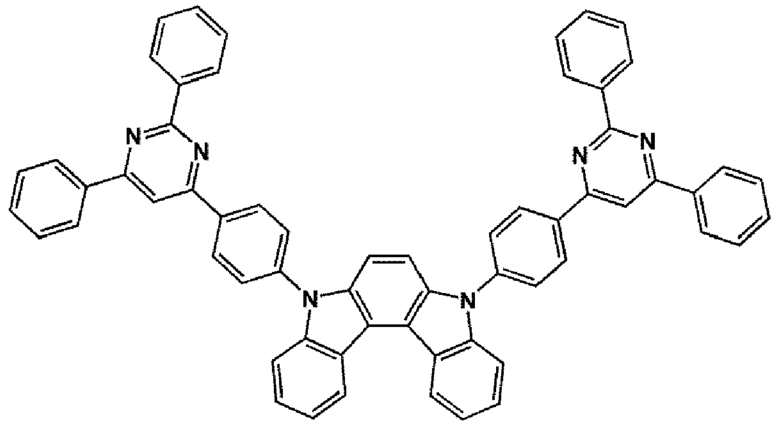

BDpyInCz

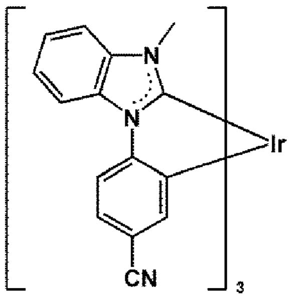

Ir-C

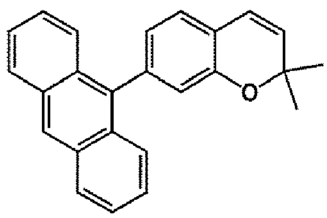

ACR

For each of Films 1, A, B, and C, the PL spectrum was evaluated at room temperature using FluoTime 300, which is a TRPL measurement system manufactured by PicoQuant Company, and manufactured by PLS340 (exciton wavelength = 340 nanometers, spectral width = 20 nanometers), which is a pumping source available from PicoQuant. Then, the wavelength of the main peak of the spectrum thus obtained was determined, and the number of photons emitted at respective wavelengths of the main peak upon the photon pulse (pulse width = 500 picoseconds) applied to each film by the PLS340 was repeatedly measured in a time-deepened manner based on the time-correlated single photon counting (TCSPC). Accordingly, TRPL curves capable of having enough fitting was obtained and shown in FIG. 4 (Film 1 (Compound 4)), FIG. 5 (Film A (BDpyInCz), FIG. 6 (Film B (Ir-C)), and FIG. 7 (Film C(ACR)).

It was confirmed that BDpyInCz was able to emit delayed fluorescence based on the TRPL curve in FIG. 5 (Film A (BDpyInCz), Ir-C was able to emit phosphorescence based on the TRPL curve in FIG. 6 (Film B(Ir-C)), and Compound 4 and ACR were able to emit general fluorescence based on the TRPL curves in FIG. 4 (Film 1 (Compound 4)) and FIG. 7 (Film C (ACR)).

Subsequently, the decay times of Films 1, A, B, and C were determined by fitting two or more exponential decay functions to the results obtained from the TRPL curves, and the results are shown in Table 3. A function used for the fitting is as shown in <Equation 1>, and the largest value among values obtained from each exponential decay functional used in the fitting was taken as the decay time for each film. Here, during the same measurement time as the measurement time taken to obtain the TRPL curves, the same measurement was repeated one more time in dark (i.e., a state in which a pumping signal incident on the predetermined film is blocked), so as to obtain a baseline or background signal curve to be used as a baseline in the fitting. In the case of Film A, among a curve of a prompt fluorescent emission substance and a curve of a delayed fluorescent emission substance, a curve of a delayed fluorescent emission substance was used to calculate decay time thereof:

<Equation 1>

$$f(t) = \sum_{i=1}^{n} A_i \, exp\left(-t/T_{decay,i}\right)$$

[Table 3]

| Film No. | Decay time (exciton lifetime) |
|---|---|
| Film 1 (Compound 4) | 6 ns |
| Film A (BDpyInCz) | 32 μs |
| Film B (Ir-C) | 14 μs |
| Film C (ACR) | 6 ns |

Referring to Table 3, it was confirmed that the exciton lifetime of Compound 4 was significantly shorter than that of BDpyInCz (TADF) and Ir-C (phosphorescence), but was similar with that of ACR (fluorescence).

## Evaluation Example 3

A transient absorption spectrum of Compound 4 was measured (at room temperature) by using a home-built pump-probe system, and results thereof and analysis data are shown in FIGS. 8A, 8B, 9A, and 9B and Table 4.

As a test sample, an acetonitrile solution (200 micromolar concentration) of Compound 4 was prepared, transient absorption spectrum measurement for $N_2$-saturated acentonitrile solution of Compound 4 was performed after bubbling of 30 minutes under $N_2$ purging, and transient absorption spectrum measurement for air-saturated acetonitrile solution of Compoun 4 was performed without $N_2$ purging.

A 320 nm pumping beam of a transient absorption spectrum measurement device was obtained from an optical parametric amplifier (Light conversion, TOPAS-C) pumped by a regerneratively amplified Ti:Sapphire laser system (Coherent, Libra, 800 nm wavelength, 50 fs pulse duration, 1 kHz repetition rate). A probe beam is a white light continuum generated by focusing a small portion of the amplifier output though a sapphire window.

FIG. 8A is a transient absorption spectrum obtained when an absorption variation (ΔmOD, a.u.) of an $N_2$-saturated acetonitrile solution of Compound 4 with respect to a wavelength (nm) is measured at 0.001 ns, 0.01 ns, 0.1 ns, and 1 ns after photoexcitation, respectively, and FIG. 9A is a transient absorption spectrum obtained when an absorption variation (ΔmOD, a.u.) of an air-saturated acetonitrile solution of Compound 4 with respect to a wavelength (nm) is measured at 0.001 ns, 0.01 ns, 0.1 ns, and 1 ns after photoexcitation, respectively.

Considering that the absorption variation at the wavelength of 1,030 nm increases in the graph measured at 0.001 ns after photoexcitation in FIG. 8A (see an arrow in FIG. 8A) 1) the absorption variation (ΔmOD, a.u.) of the $N_2$-saturated acetonitrile solution of Compound 4 and the air-saturated acetonitrile solution of Compound 4 with respect to the time (ps) for the wavelength of 1,030 nm was measured, and results thereof are shown in FIGS. 8B and 9B, and 2) two absorption decay times that could be observed from FIGS. 8B and 9B, that is, $\tau_2$ and $\tau_3$, were evaluated, and results thereof are shown in Table 4.

[Table 4]

| | $\tau_2$ (ps) | $\tau_3$ (ns) |
|---|---|---|
| $N_2$-saturated acetonitrile solution of Compound 4 | 41 | 4.1 |
| air-saturated acetonitrile solution of Compound 4 | 23 | 2.9 20 |

Referring to Table 4, $\tau_2$ of the air-saturated acetonitrile solution of Compound 4 with respect to the light of 1,030 nm was more reduced than $\tau_2$ of the $N_2$-saturated acetonitrile solution of Compound 4 with respect to the light of 1,030 nm, and $\tau_3$ of the air-saturated acentonitrile solution of Compound 4 with respect to the light of 1,030 nm was more reduced than $\tau_3$ of the $N_2$-saturated acetonitrile solution of Compound 4 with respect to the light of 1,030 nm. By this Table 4, a remarkable difference in absorption decay time according to the presence or absence of oxygen was confirmed. Therefore, the excited state of Compound 4 observed at the wavelength of 1,030 nm in FIG. 8A may be determined as not a singlet state but a triplet state.

On the other hand, since 3.8 eV, which is the pump energy of the pump beam of 320 nm used for optical excitation, is equal to the energy level of the $^1\pi$-$\pi^*$ excited state of Compound 4 (see Table 1), the initial excited state of Compound 4 may be determined as the $^1\pi$-$\pi^*$ excited state. The excited state of Compound 4 at the wavelength of 1,030 nm (determined as the triplet state as described above) may be observed from the transient absorption spectrum of FIG. 8A (that is, the absorption variation at the wavelength of 1,030 nm increases). This transient absorption spectrum of FIG. 8A may be an evidence for a transition of more than a part of energy of the $^1\pi$-$\pi^*$ excited state generated by

photoexcitation to the excited state at the wavelength of 1,030 nm. In summary, according to El-Sayed rule, the excited state of Compound 4 at the wavelength of 1,030 nm may be determined as not the triplet state of the ground state not the $^3$n-$\pi$* excited state.

Therefore, it is confirmed that Compound 4 may have the $^3$n-$\pi$* excited state. In Table 4, $\tau_2$ (in tens ps order) may be defined as the absorption decay time observed when Compound 4 transits from the $^1\pi$-$\pi$* excited state to the $^3$n-$\pi$* excited state, and $\tau_3$ (in numbers ns order) may be defined as the absorption decay time observed when Compound 4 transits from the $^1\pi$-$\pi$* excited state to the lowest triplet state.

## Example 1

As an anode, a glass substrate on which an ITO electrode was formed was cut to a size of 50 mm x 50 mm x 0.5 mm, sonicated with acetone isopropyl alcohol and pure water each for 15 minutes, and then, cleaned by exposure to ultraviolet rays for 30 minutes.

Compounds HT3 and HT-D2 (HT-D2 having a concentration of 3 wt%) were co-deposited on the anode to form a hole injection layer having a thickness of 100 Å. Compound HT3 was deposited on the hole injection layer to form a hole transport layer having a thickness of 1,500 Å, and mCP was deposited on the hole transport layer to form an electron blocking layer having a thickness of 100 Å, thereby forming a hole transport region having a thickness of 1,700 Å.

Compound mCBP (host) and Compound 4 (dopant) were co-deposited on the hole transport region at a volume ratio of 85:15, thereby forming an emission layer having a thickness of 400 Å.

Compound BCP was vacuum-deposited on the emission layer to form a hole blocking layer having a thickness of 100 Å, and Compound ET17 and LiQ were co-deposited on the hole blocking layer at a weight ratio of 5:5 to form an electron transport layer having a thickness of 360 Å. Then, LiQ was deposited on the electron transport layer to form an electron injection layer having a thickness of 5 Å, and Al was formed on the electron injection layer, thereby completing the manufacture of an organic light-emitting device:

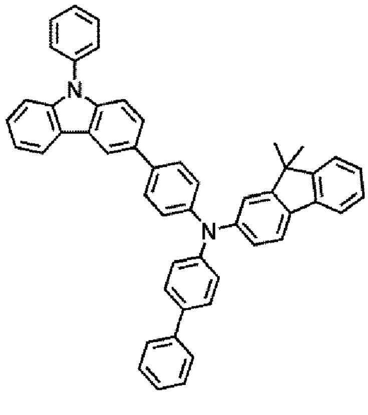
HT3

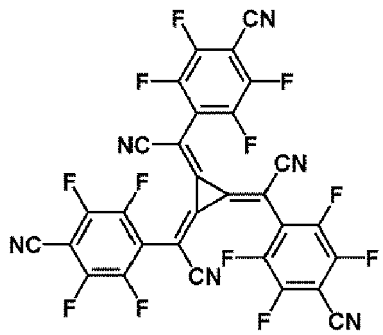
HT-D2

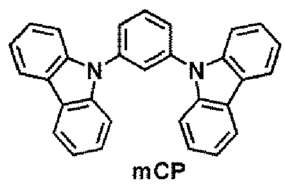
mCP

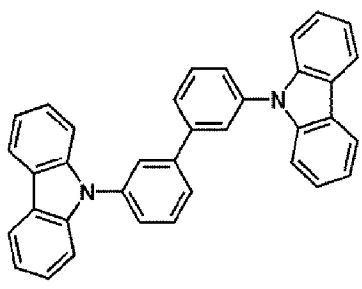
mCBP

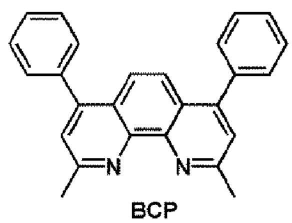
BCP

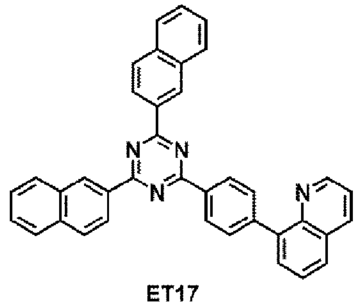
ET17

.

## Examples 2 to 5 and Comparative Examples A and B

An organic light-emitting device was manufactured in the same manner as in Example 1, except that a material

shown in Tables 5 and 6 was used instead of the dopant in forming an emission layer.

**Evaluation Example 4**

The brightness, emission efficiency, maximum external quantum efficiency ($EQE_{max}$), photoluminescence quantum yield (PLQY), internal quantum efficiency (IQE), and lifetime ($T_{80}$) of the organic light-emitting devices of Examples 1 to 5 and Comparative Examples A and B were measured by using Keithley 2400 current-voltage meter and Minolta Cs-1000A luminance meter, and the results are summarized in Tables 5 and 6. The lifetime ($T_{80}$) (at 500 cd/$m^2$) was a time required to degrade brightness to 80% of an initial brightness (100%), and the IQE/PLQY was calculated under the assumption that the outcoupling efficiency of the organic light-emitting device was 0.2264.

[Table 5]

| | Dopant | Brightness (cd/$m^2$) | emission efficiency (cd/A) | $EQE_{max}$ (%) | PLQY (%) | IQE (%) | IQE/ PLQY (%) | Lifetime ($T_{80}$) (hr) |
|---|---|---|---|---|---|---|---|---|
| Example 1 | Compound 4 | 500 | 3.31 | 3.3 | 47.9 | 16.5 | 30.4 | 1.77 |
| Comparative Example A | ACR | 500 | 0.96 | 2.9 | 51.4 | 14.5 | 25 | 0.04 |

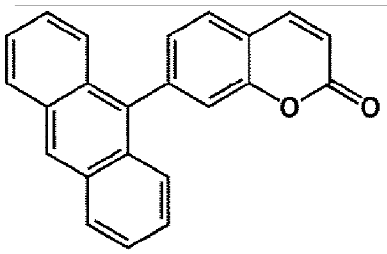

4

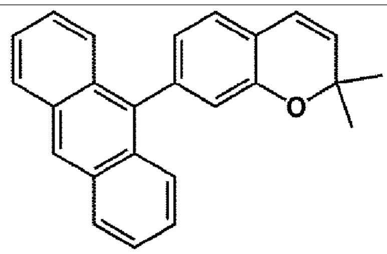

ACR

[Table 6]

| | Dopant | Brightness (cd/$m^2$) | emission efficiency (cd/A) | $EQE_{max}$ (%) | PLQY (%) | IQE (%) | IQE/ PLQY (%) |
|---|---|---|---|---|---|---|---|
| Example 2 | Compound 1 | 500 | 1.5 | 3.7 | 48.9 | 18.7 | 38.3 |
| Example 3 | Compound 2 | 500 | 1.4 | 2.6 | 28.4 | 12.9 | 45.5 |
| Example 4 | Compound 7 | 500 | 2.3 | 4.8 | 54.2 | 24.1 | 44.4 |
| Example 5 | Compound 8 | 500 | 1.2 | 3.8 | 59.4 | 19.2 | 32.4 |
| Comparative Example B | DPA | 500 | 1.2 | 3.9 | 72.4 | 19.3 | 26.6 |

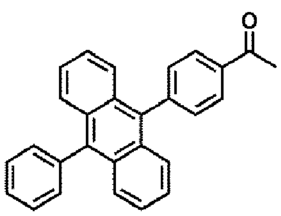

1

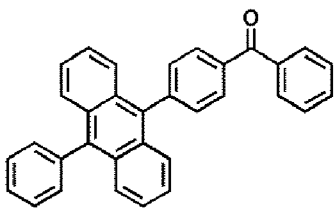

2

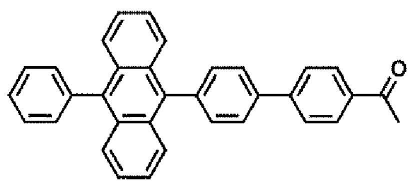

7

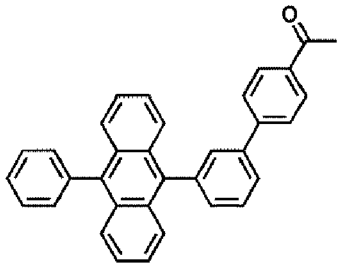

8

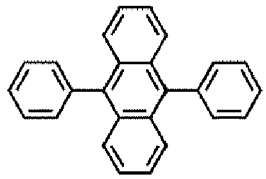

DPA

Referring to Tables 5 and 6, it was confirmed that the organic light-emitting device of Example 1 exhibited both excellent emission efficiency and long lifetime as compared with the organic light-emitting device of Comparative Example A and the organic light-emitting devices of Examples 2 to 5 exhibited both excellent emission efficiency and long lifetime as compared with the organic light-emitting device of Comparative Example B. Although not particularly limited to a specific theory, the organic light-emitting devices of Examples 1 to 5 exhibited the spin statics (i.e., IQE/PLQY) which is significantly higher than the spin statics of about 25% seen in a conventional fluorescence device (i.e., the organic light-emitting device of Comparative Examples A and B), confirming that fluorescence utilizing triplet excitons in the $^{3}$n-$\pi^{*}$ excited state was available, unlike a conventional fluorescence device. Furthermore, referring to Evaluation Example 2, it was also confirmed that Compound 4 showed the decay time at a fluorescence emission level. Thus, it was confirmed that, unlike conventional phosphorescence emission or TADF emission, Compound 4 had a mechanism of emitting light after rapid transition, which is allowed according to the El-Sayed's Rule, from the $^{3}$n-$\pi^{*}$ excited state to the $^{1}\pi$-$\pi^{*}$ excited state.

In the fluorescent compound, since the fluorescence is emitted by radiative transition of the exciton thereof in the $^{1}\pi$-$\pi^{*}$ excited state, which is transferred from the $^{3}$n-$\pi^{*}$ excited state of the fluorescent compound to the $^{1}\pi$-$\pi^{*}$ excited state of the fluorescent compound, to a ground state, the triplet excitons can contribute to fluorescence emission. Accordingly, the fluorescent compound may be able to provide high luminance and/or high emission efficiency. At the same time, the fluorescent compound can finally emit fluorescence by transferring of the triplet exciton in the $^{3}$n-$\pi^{*}$ excited state to the $^{1}\pi$-$\pi^{*}$ excited state via the allowed transition according to the El-Sayed's Rule, thereby having a relatively short exciton lifetime (i.e., decay time). In this regard, the fluorescent compound may have a low probability of deterioration, and an electronic device, for example, an organic light-emitting device including the fluorescent compound may have a long lifetime. In addition, the since the fluorescent compound was not an expensive metal-containing compound, using such as iridium, platinum, or the like, an electronic device, for example, an organic light-emitting device, including the fluorescent compound may not cause an increase in the manufacturing cost thereof.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

**1.** An organic light-emitting device comprising:

a first electrode;
a second electrode facing the first electrode; and
an organic layer disposed between the first electrode and the second electrode and comprising an emission layer and a fluorescent compound,
wherein the fluorescent compound has $^{3}$n-$\pi^{*}$-to-$^{1}\pi$-$\pi^{*}$ transition from a $^{3}$n-$\pi^{*}$ excited state to a $^{1}\pi$-$\pi^{*}$ excited state,
an energy level (eV) in a $^{1}$n-$\pi^{*}$ excited state of the fluorescent compound is greater than an energy level (eV) in the $^{1}\pi$-$\pi^{*}$ excited state of the fluorescent compound,
the fluorescent compound emits fluorescence by radiative transition of an exciton thereof in the $^{1}\pi$-$\pi^{*}$ excited state to a ground state,
"$^{3}$" in the expression "$^{3}$n-$\pi^{*}$" indicates a triplet state, and "$^{1}$" in the expressions "$^{1}$n-$\pi^{*}$" and "$^{1}\pi$-$\pi^{*}$" indicates a singlet state, and
the energy level in the $^{1}$n-$\pi^{*}$ excited state, the energy level in the $^{1}\pi$-$\pi^{*}$ excited state, and the energy level in

the $^3$n-π* excited state are each independently calculated by using structurally optimized time dependent-density functional theory (TD-DFT) at a CAM-B3LYP/6-311+G(d,p) level.

2. The organic light-emitting device of claim 1, wherein an energy level in the $^3$n-π* excited state of the fluorescent compound is greater than the energy level in the $^1$π-π* excited state of the fluorescent compound.

3. The organic light-emitting device of claims 1 or 2, wherein an energy level in the $^3$n-π* excited state of the fluorescent compound is less than the energy level in the $^1$π-π* excited state of the fluorescent compound; and/or wherein a difference between i) an energy level in the $^3$n-π* excited state of the fluorescent compound and ii) the lowest energy level of the energy level(s) in the $^1$π-π* excited state of the fluorescent compound is 1.00 eV or less.

4. The organic light-emitting device of any of claims 1-3, wherein an exciton in the $^3$n-π* excited state of the fluorescent compound is transferred to the $^1$π-π* excited state of the fluorescent compound via reverse intersystem crossing (rISC).

5. The organic light-emitting device of any of claims 1-4, wherein the fluorescence is emitted by radiative transition of the exciton thereof in the $^1$π-π* excited state, which is transferred from the $^3$n-π* excited state of the fluorescent compound to the $^1$π-π* excited state of the fluorescent compound via reverse intersystem crossing (rISC), to a ground state;
preferably wherein a rate of the rISC is in a range of $10^6$ $s^{-1}$ to $10^8$ $s^{-1}$.

6. The organic light-emitting device of any of claims 1-5, wherein the fluorescent compound has an exciton lifetime in a range of 0.1 ns to 1 μs.

7. The organic light-emitting device of any of claims 1-6, wherein
an energy level in the $^3$n-π* excited state of the fluorescent compound is less than an energy level in the $^3$π-π* excited state of the fluorescent compound,
"3" in the expression "$^3$π-π*" indicates a triplet state,
the energy level in the $^3$π-π* excited state is calculated by using structurally optimized time dependent-density functional theory (TD-DFT) at a CAM-B3LYP/6-311+G(d,p) level.

8. The organic light-emitting device of any of claims 1-7, wherein the fluorescent compound comprises a non-bonding orbital that is able to induce the $^3$nπ*-to-$^1$π-π* transition from a $^3$n-π* excited state to a $^1$π-π* excited state.

9. The organic light-emitting device of any of claims 1-8, wherein the fluorescent compound comprises at least one carbonyl group.

10. The organic light-emitting device of any of claims 1-9, wherein the fluorescent compound is represented by Formula 1 or 2:

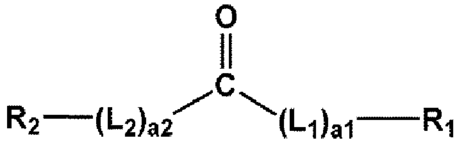

1

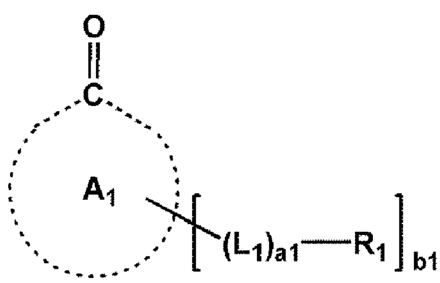

2

,

wherein in Formulae 1 and 2,

ring $A_1$ is a carbonyl-containing $C_5$-$C_{60}$ carbocyclic group or a carbonyl-containing $C_1$-$C_{60}$ heterocyclic group,
$L_1$ and $L_2$ are each independently a substituted or unsubstituted $C_1$-$C_{60}$ alkylene group, a substituted or unsubstituted $C_2$-$C_{60}$ alkenylene group, a substituted or unsubstituted $C_2$-$C_{60}$ alkynylene group, a substituted or

unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,

a1 and a2 are each independently an integer from 0 to 20,

$R_1$ and $R_2$ are each independently selected from hydrogen, deuterium, -F, -Cl, -Br,-I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -B($Q_6$)($Q_7$), and -P(=O)($Q_8$)($Q_9$),

b1 is an integer from 1 to 20,

at least one substituent of the substituted $C_1$-$C_{60}$ alkylene group, the substituted $C_2$-$C_{60}$ alkenylene group, the substituted $C_2$-$C_{60}$alkynylene group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, substituted divalent non-aromatic condensed polycyclic group, substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, substituted monovalent non-aromatic condensed polycyclic group, and the substituted monovalent non-aromatic condensed heteropolycyclic group is selected from:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I,-$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group,-N($Q_{11}$)($Q_{12}$), -Si($Q_{13}$)($Q_{14}$)($Q_{15}$), -B($Q_{16}$)($Q_{17}$), and -P(=O)($Q_{18}$)($Q_{19}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, -$CD_3$, -$CD_2H$, -$CDH_2$,-$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_{21}$)($Q_{22}$),-Si(Q23)(Q24)(Q25),

-B(Q26)(Q27), and -P(=O)($Q_{28}$)($Q_{29}$); and
-N($Q_{31}$)($Q_{32}$), -Si($Q_{33}$)($Q_{34}$)($Q_{35}$), -B($Q_{36}$)($Q_{37}$), and -P(=O)($Q_{38}$)($Q_{39}$), and

$Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;
preferably wherein a core represented by

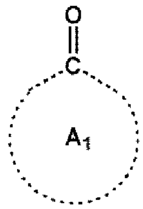

in Formula 2 is a group represented by one selected form Formulae 2-1 to 2-15:

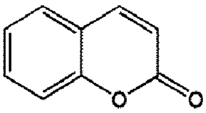
2-1

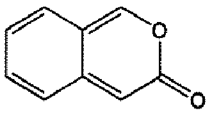
2-2

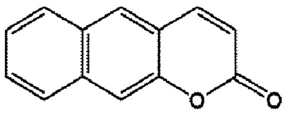
2-3

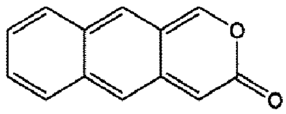
2-4

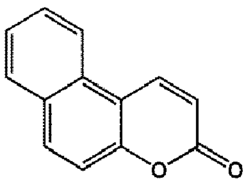
2-5

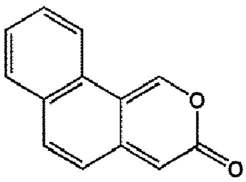
2-6

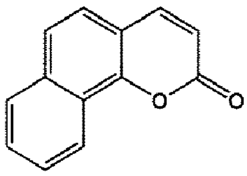
2-7

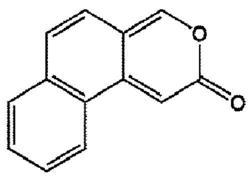
2-8

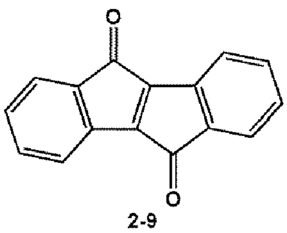
2-9

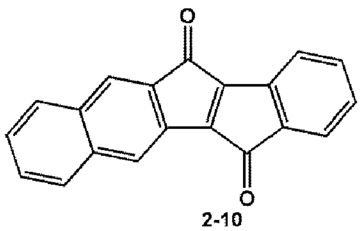
2-10

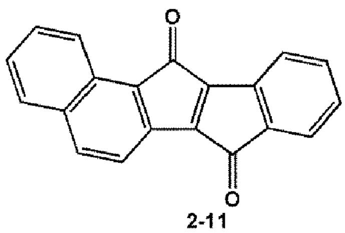
2-11

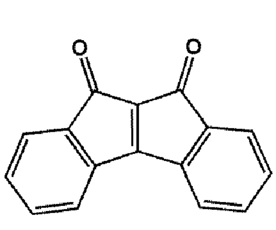
2-12

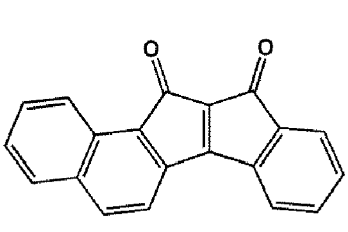
2-13

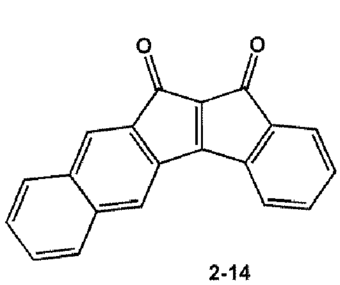
2-14

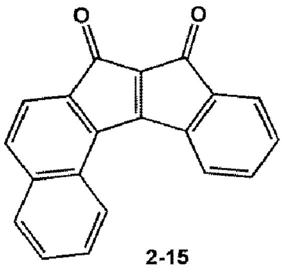

2-15

11. The organic light-emitting device of any of claims 1-10, wherein the fluorescent compound is one selected from Compounds 1 to 8:

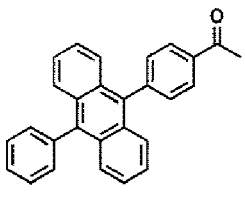

1

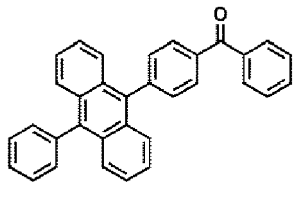

2

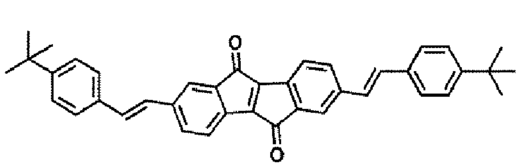

3

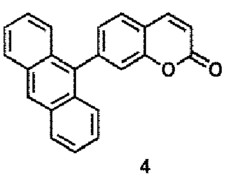

4

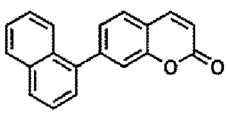

5

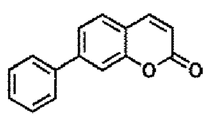

6

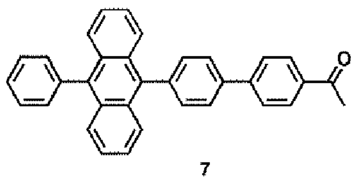

7

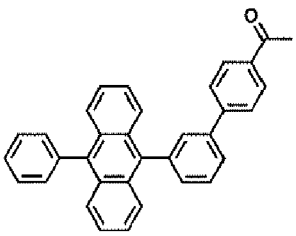

8

12. The organic light-emitting device of any of claims 1-11, wherein the emission layer comprises the fluorescent compound.

13. The organic light-emitting device of claim 12, wherein, a ratio of an emission portion of the fluorescence emitted by radiative transition of the exciton thereof in the $^{1}\pi$-$\pi^*$ excited state, which is transferred from the $^{3}$n-$\pi^*$ excited state of the fluorescent compound to the $^{1}\pi$-$\pi^*$ excited state of the fluorescent compound via reverse intersystem crossing (rISC), to a ground state, to a total emission portion emitted from the emission layer is at least 90%; and/or wherein the emission layer further comprises a host.

14. The organic light-emitting device of any of claims 1-13, wherein the organic layer comprises a hole transport region disposed between the first electrode and the emission layer and an electron transport region disposed between the emission layer and the second electrode,
wherein the hole transport region comprises a hole injection layer, a hole transport layer, an electron blocking layer, a buffer layer or any combination thereof, and
the electron transport region comprises a hole blocking layer, an electron transport layer, an electron injection layer, or any combination thereof.

15. A fluorescent compound, wherein
the fluorescent compound has $^{3}$n-$\pi^*$-to-$^{1}\pi$-$\pi^*$ transition from a $^{3}$n-$\pi^*$ excited state to a $^{1}\pi$-$\pi^*$ excited state,

an energy level (eV) in a $^{1}n-\pi^{*}$ excited state of the fluorescent compound is greater than an energy level (eV) in the $^{1}\pi-\pi^{*}$ excited state of the fluorescent compound,

the fluorescent compound emits fluorescence by radiative transition of an exciton thereof in the $^{1}\pi-\pi^{*}$ excited state to a ground state,

"$^{3}$" in the expression "$^{3}n-\pi^{*}$" indicates a triplet state, and "$^{1}$" in the expressions "$^{1}n-\pi^{*}$" and "$^{1}\pi-\pi^{*}$" indicates a singlet state, and

the energy level in the $^{1}n-\pi^{*}$ excited state, the energy level in the $^{1}\pi-\pi^{*}$ excited state, and the energy level in the $^{3}n-\pi^{*}$ excited state are each independently calculated by using structurally optimized time dependent-density functional theory (TD-DFT) at a CAM-B3LYP/6-311+G(d,p) level, and

a coumarin-based compound represented by Formula 1' is excluded from the fluorescent compound:

<Formula 1'>

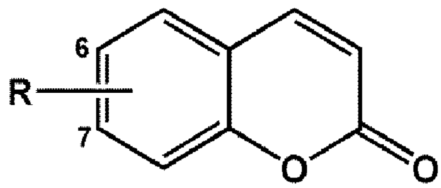,

wherein, R in Formula 1' is a $C_6$-$C_{50}$ aryl group positioned at the 6-position or 7-position of a coumarin ring in Formula 1';

preferably wherein the fluorescent compound comprises at least one carbonyl group.

FIG. 1

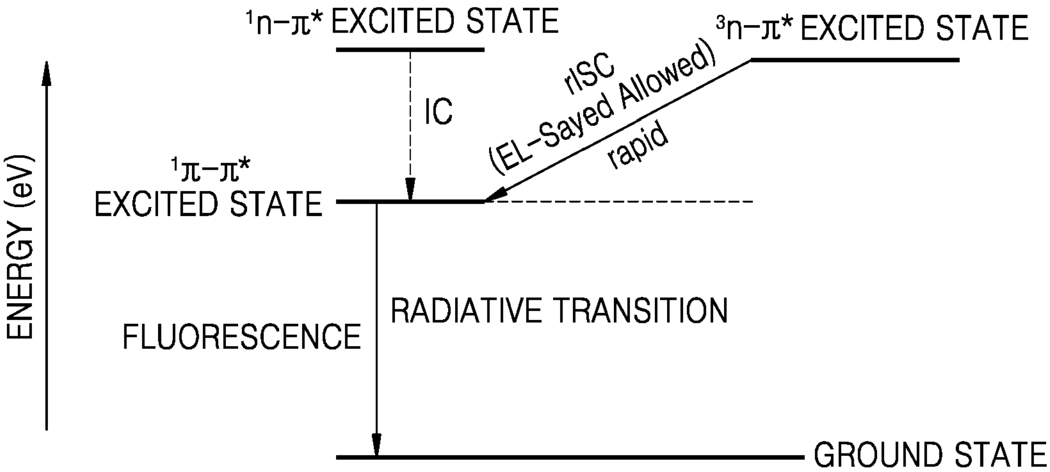

$^1n-\pi^*$ EXCITED STATE
$^3n-\pi^*$ EXCITED STATE
IC
rISC
(EL-Sayed Allowed)
rapid
$^1\pi-\pi^*$
EXCITED STATE
ENERGY (eV)
FLUORESCENCE
RADIATIVE TRANSITION
GROUND STATE


FIG. 2

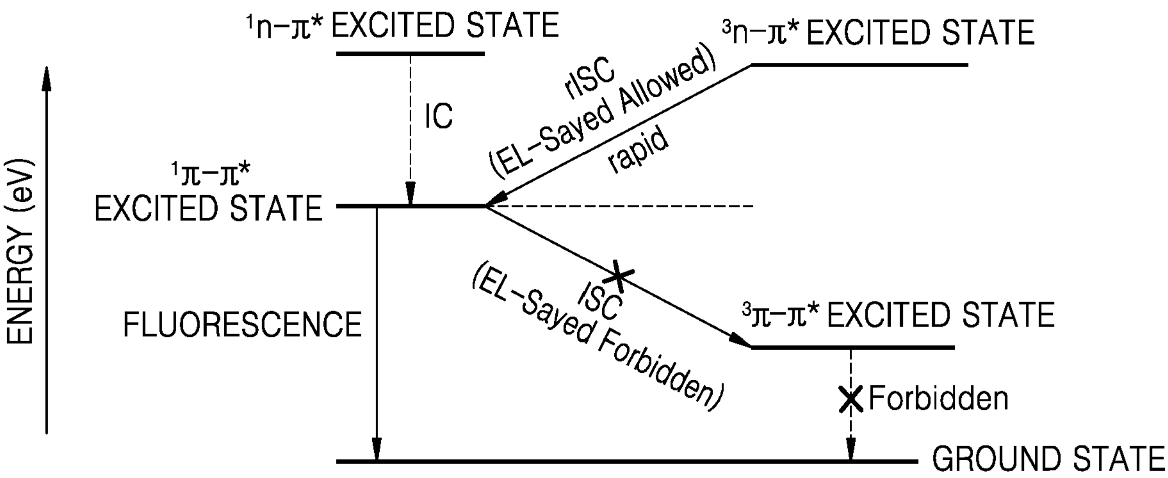

$^1n-\pi^*$ EXCITED STATE
$^3n-\pi^*$ EXCITED STATE
IC
rISC
(EL-Sayed Allowed)
rapid
$^1\pi-\pi^*$
EXCITED STATE
ENERGY (eV)
ISC
(EL-Sayed Forbidden)
$^3\pi-\pi^*$ EXCITED STATE
FLUORESCENCE
Forbidden
GROUND STATE

FIG. 3

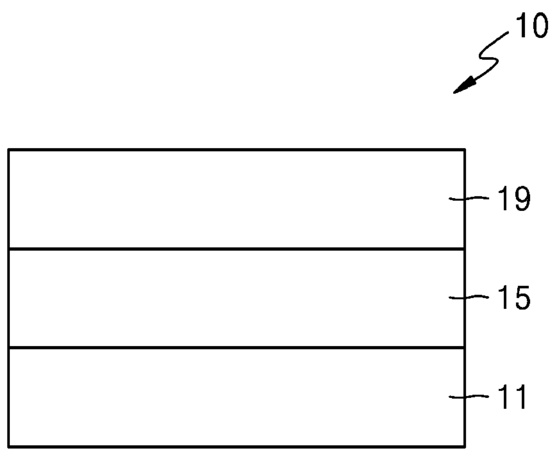

FIG. 4

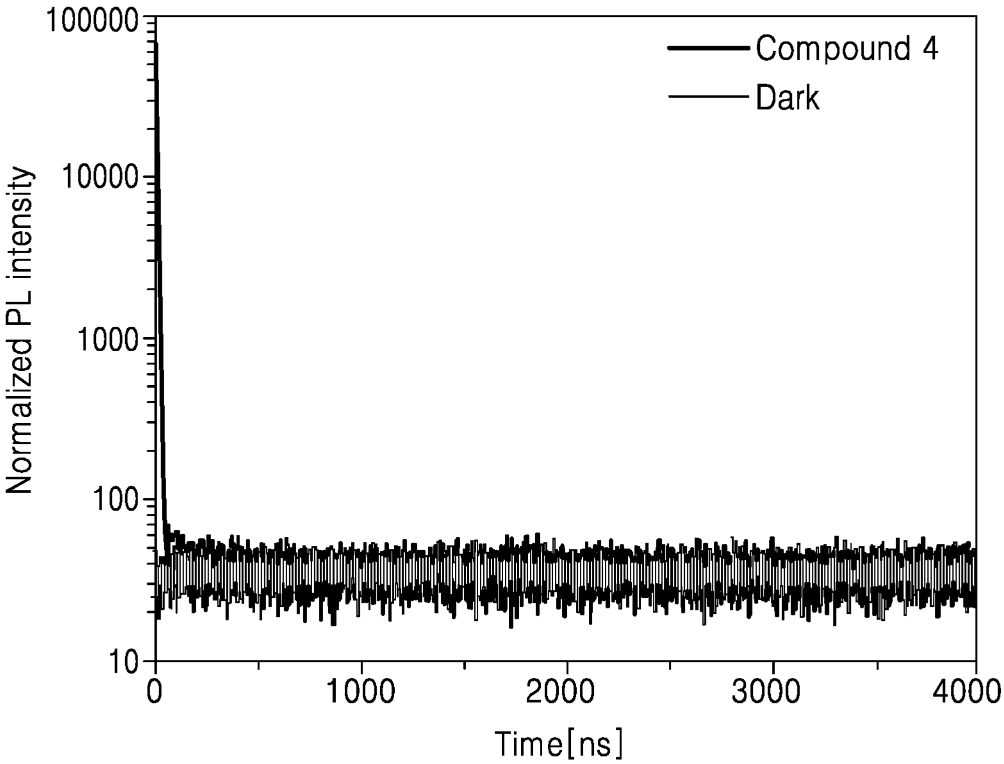
Compound 4
Dark
Normalized PL intensity
100000
10000
1000
100
10
0
1000
2000
3000
4000
Time[ns]

FIG. 5

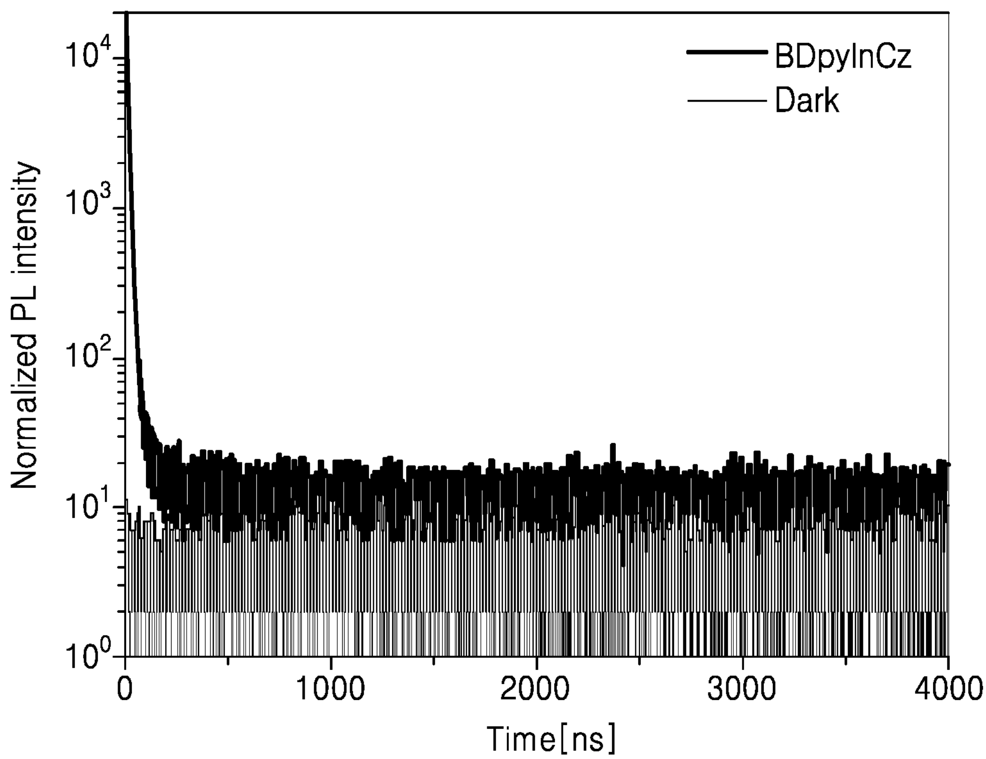
BDpyInCz
Dark
Normalized PL intensity
$10^4$
$10^3$
$10^2$
$10^1$
$10^0$
0
1000
2000
3000
4000
Time[ns]

FIG. 6

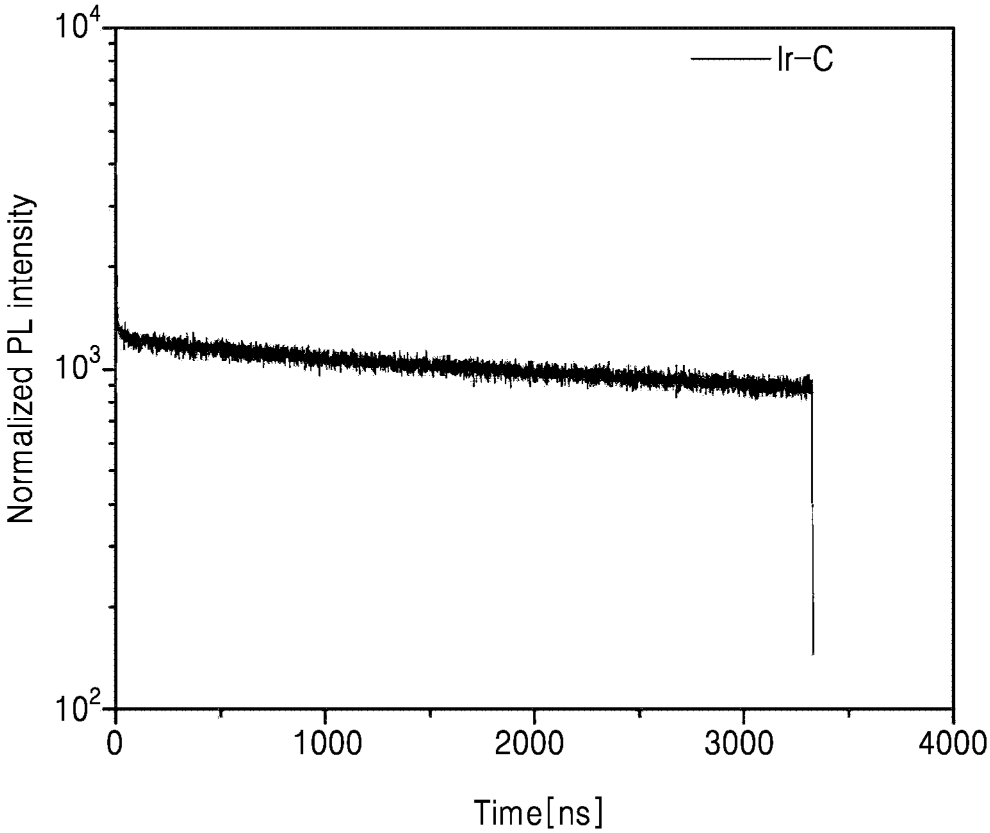
Ir−C
Normalized PL intensity
$10^4$
$10^3$
$10^2$
0
1000
2000
3000
4000
Time[ns]

FIG. 7

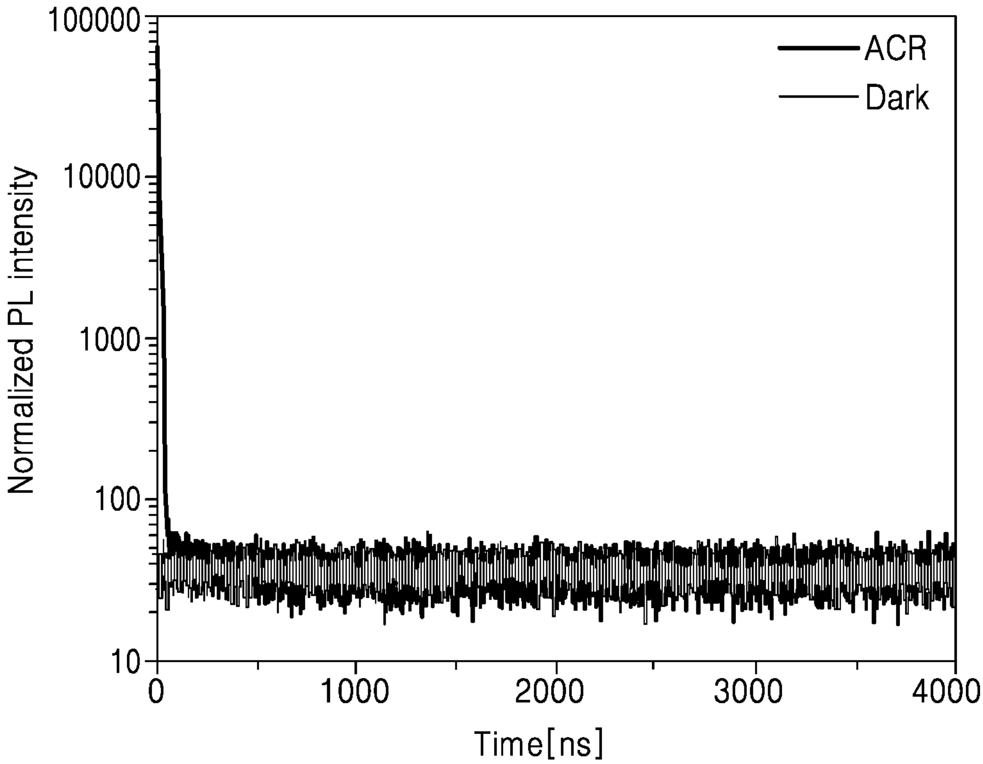
100000
10000
1000
100
10
Normalized PL intensity
ACR
Dark
0
1000
2000
3000
4000
Time[ns]

FIG. 8A

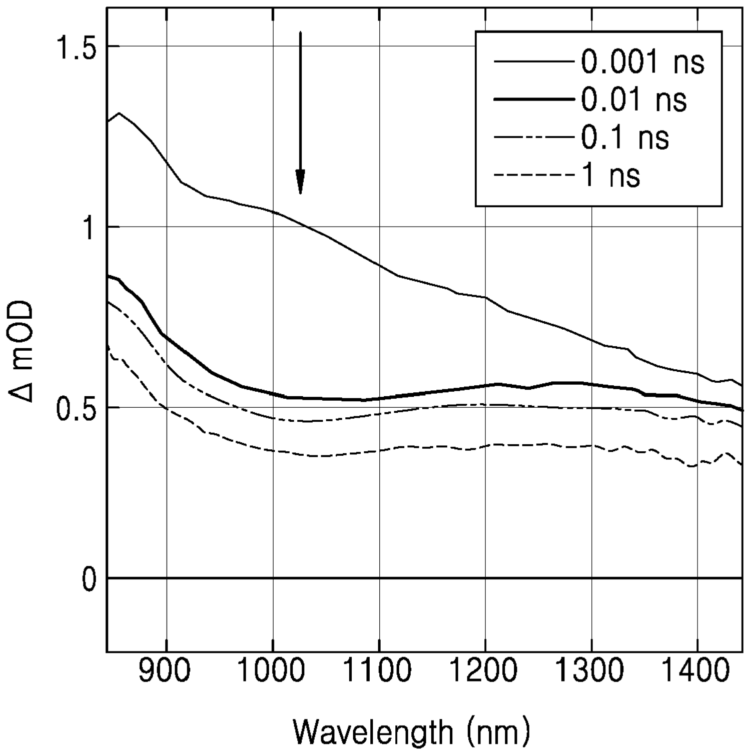
0.001 ns
0.01 ns
0.1 ns
1 ns
1.5
1
0.5
0
Δ mOD
900
1000
1100
1200
1300
1400
Wavelength (nm)

FIG. 8B

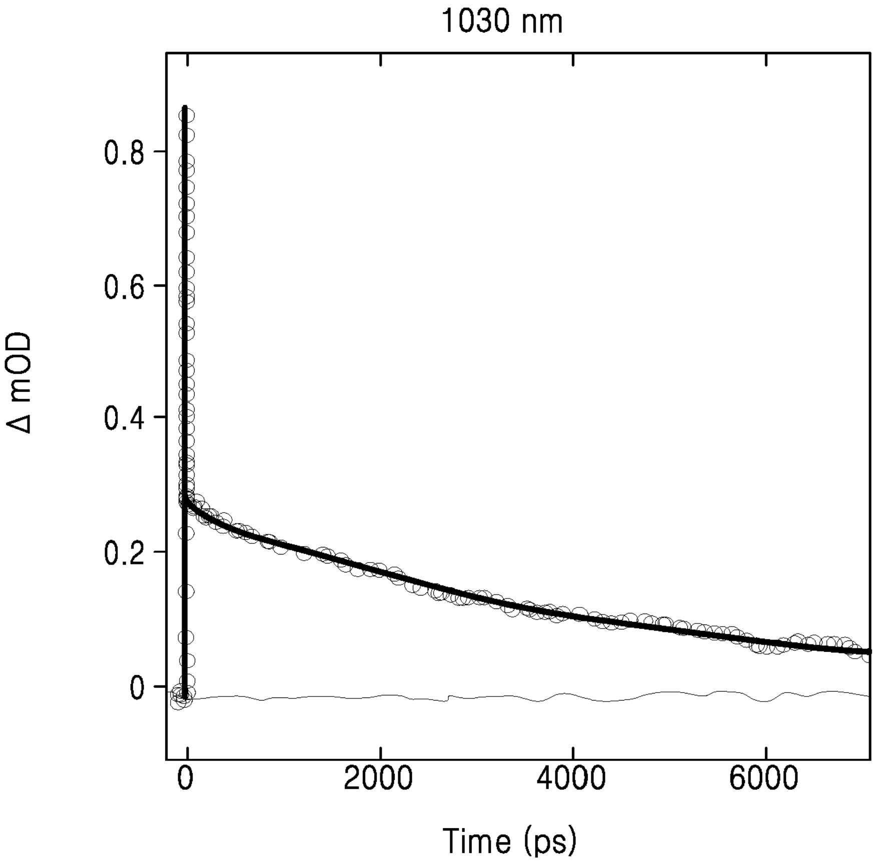

# FIG. 9A

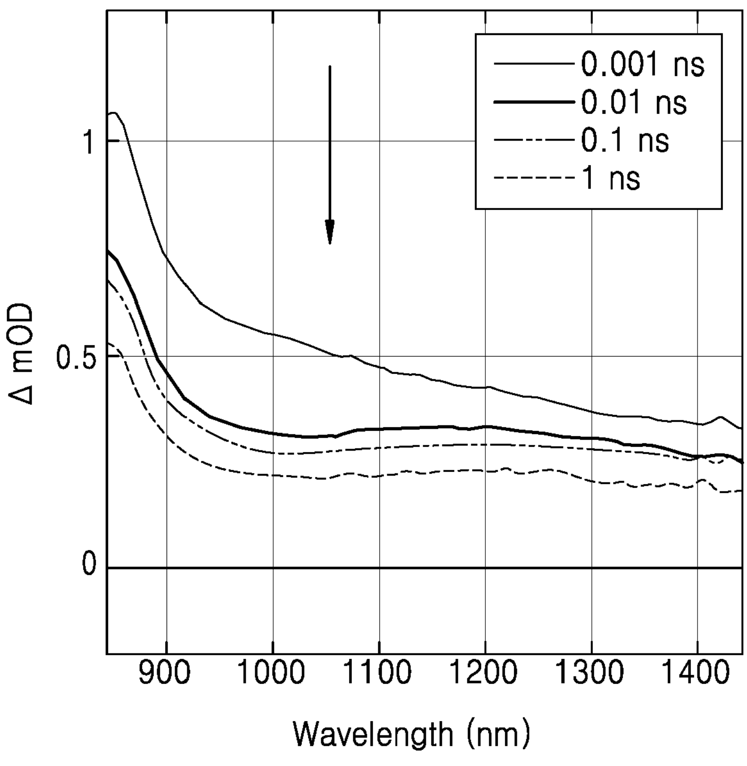
0.001 ns
0.01 ns
0.1 ns
1 ns
Δ mOD
1
0.5
0
900
1000
1100
1200
1300
1400
Wavelength (nm)

FIG. 9B

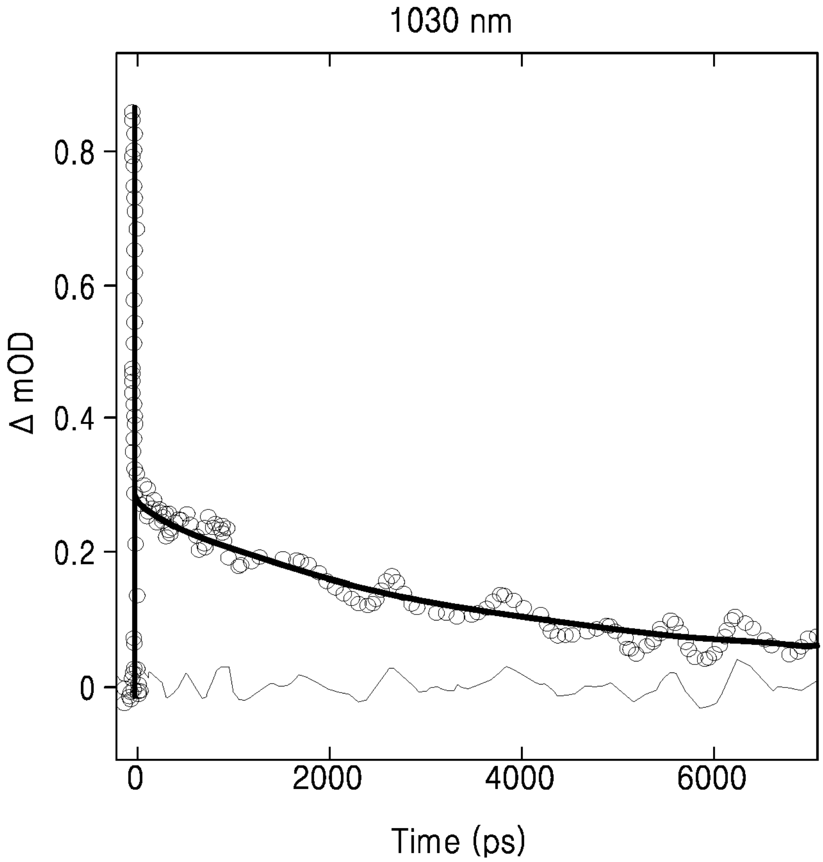

Europäisches Patentamt
European Patent Office
Office européen des brevets

# EUROPEAN SEARCH REPORT

Application Number
EP 18 19 1309

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | D. HU ET AL: "Reverse intersystem crossing from upper triplet levels to excited singlet: a 'hot excition' path for organic light-emitting diodes", ROYAL SOCIETY OF LONDON. PHILOSOPHICAL TRANSACTIONS.MATHEMATICAL, PHYSICAL AND ENGINEERING SCIENCES, vol. 373, no. 2044, 18 May 2015 (2015-05-18), pages 20140318-20140318, XP055543539, GB ISSN: 1364-503X, DOI: 10.1098/rsta.2014.0318 * figures 1,4, 7; compounds TPA-AC, TPA-NZP * ----- | 1,3-8,15 | INV. H01L51/54 |
| X | DEHUA HU ET AL: "28.2: Invited Paper : Reverse Intersystem Crossing From High-lying Triplet Energy Levels to Excited Singlet: A "Hot excition" Path for OLEDs", S I D INTERNATIONAL SYMPOSIUM. DIGEST OF TECHNICAL PAPERS, vol. 46, no. 1, 29 July 2015 (2015-07-29), pages 404-407, XP055543867, US ISSN: 0097-966X, DOI: 10.1002/sdtp.10380 * figures 2,3,6; compounds TPA-AC * ----- | 1,3-5,8, 15 | TECHNICAL FIELDS SEARCHED (IPC) H01L |
| X | TOHRU SATO ET AL: "Fluorescence via Reverse Intersystem Crossing from Higher Triplet States in a Bisanthracene Derivative", SCIENTIFIC REPORTS, vol. 7, no. 1, 6 July 2017 (2017-07-06), XP055543938, DOI: 10.1038/s41598-017-05007-7 * figures 1,6; compound BD1 * ----- -/-- | 1,3,4,8, 15 | |

The present search report has been drawn up for all claims

1

| Place of search | Date of completion of the search | Examiner |
|---|---|---|
| The Hague | 18 January 2019 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 18 19 1309

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/150327 A1 (KAWAI TATSUNDO [JP] ET AL) 5 August 2004 (2004-08-05)<br>* figure 1; compound Formula 4 on page 14 *<br>----- | 1,2,4,8, 15 | |
| X | JP 2005 314239 A (MITSUI CHEMICALS INC) 10 November 2005 (2005-11-10)<br>* example 29; compound compound 211 *<br>----- | 1,9-15 | |
| X | CHRISTEL M. MARIAN ET AL: "Reverse Intersystem Crossing in Rhodamines by Near-Infrared Laser Excitation",<br>JOURNAL OF PHYSICAL CHEMISTRY. A, MOLECULES, SPECTROSCOPY,KINETICS, ENVIRONMENT AND GENERAL THEORY,<br>vol. 118, no. 34,<br>19 August 2014 (2014-08-19), pages 6985-6990, XP055543275,<br>US<br>ISSN: 1089-5639, DOI: 10.1021/jp506904v<br>* figure included in abstract; compound rhodamine RhA *<br>----- | 15 | TECHNICAL FIELDS SEARCHED (IPC) |
| A | BYUNG HAK JHUN ET AL: "Synthetic control over intra- and intermolecular charge transfer can turn on the fluorescence emission of non-emissive coumarin",<br>JOURNAL OF MATERIALS CHEMISTRY C,<br>vol. 4, no. 20, 6 April 2016 (2016-04-06), pages 4556-4567, XP055544032,<br>UK<br>ISSN: 2050-7526, DOI: 10.1039/C6TC00639F<br>* figures 1, Scheme 1, Scheme 2 *<br>----- | 1-15 | |

1

The present search report has been drawn up for all claims

| Place of search | Date of completion of the search | Examiner |
|---|---|---|
| The Hague | 18 January 2019 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 18 19 1309

This annex lists the patent family members relating to the patent documents cited in the above-mentioned European search report. The members are as contained in the European Patent Office EDP file on
The European Patent Office is in no way liable for these particulars which are merely given for the purpose of information.

18-01-2019

| Patent document cited in search report | Publication date | Patent family member(s) | Publication date |
|---|---|---|---|
| US 2004150327 A1 | 05-08-2004 | JP 2004214180 A<br>US 2004150327 A1 | 29-07-2004<br>05-08-2004 |
| JP 2005314239 A | 10-11-2005 | JP 4384536 B2<br>JP 2005314239 A | 16-12-2009<br>10-11-2005 |

EPO FORM P0459

For more details about this annex : see Official Journal of the European Patent Office, No. 12/82